# EUROPEAN PATENT APPLICATION

(11) **EP 4 708 296 A1**
(43) Date of publication of application: **11.03.2026**
(21) Application number: 25154070.4
(22) Date of filing: 27.01.2025
(51) Int. Cl.: G11C 16/08, G11C 16/26, G11C 8/08, G11C 29/02, G11C 29/52, G11C 16/04, G11C 11/56, G11C 29/04, G11C 29/44

(54) **MEMORY DEVICE AND MEMORY SYSTEM**

(30) Priority: 10.09.2024 JP 2024156650
(71) Applicant: Kioxia Corporation, Tokyo 108-0023 (JP)
(72) Inventor: MAEJIMA, Hiroshi, Minato-ku, Tokyo, 108-0023 (JP); KODAMA, Takuyo, Minato-ku, Tokyo, 108-0023 (JP); ISOBE, Katsuaki, Minato-ku, Tokyo, 108-0023 (JP)
(74) Representative: Hoffmann Eitle

(57) **Abstract**

A memory device according to one embodiment includes strings, bit lines, word lines, a source line, and a controller. Each of the strings includes memory cells. The word lines are respectively coupled to the memory cells in each of the strings. The controller is configured to execute a first read operation including a first read sequence and a second read sequence. The controller is further configured to: in the first read sequence, increase voltages of the word lines at the same speed, and determine a correction value of each of a plurality of read voltages based on a timing at which an amount of current through the strings changes with an increase in voltages of the word lines; and in the second read sequence, execute a read operation using the read voltages to which the correction value is applied.

## Description

### CROSS-REFERENCE TO RELATED APPLICATIONS

This application is based upon and claims the benefit of priority from Japanese Patent Application No. 2024-156650, filed September 10, 2024.

### FIELD

Embodiments described herein relate generally to a memory device and a memory system.

### BACKGROUND

A NAND flash memory capable of storing data in a non-volatile manner is known.

### BRIEF DESCRIPTION OF THE DRAWINGS

FIG. 1 is a block diagram illustrating an example of a configuration of a memory system according to a first embodiment.
FIG. 2 is a block diagram illustrating an example of a hardware configuration of a memory controller included in the memory system according to the first embodiment.
FIG. 3 is a block diagram illustrating an example of a hardware configuration of a memory device included in the memory system according to the first embodiment.
FIG. 4 is a diagram illustrating an example of a circuit configuration of a memory cell array included in the memory device according to the first embodiment.
FIG. 5 is a diagram illustrating an example of a circuit configuration of a row decoder module included in the memory device according to the first embodiment.
FIG. 6 is a diagram illustrating an example of a configuration of a sense amplifier module and a data register included in the memory device according to the first embodiment.
FIG. 7 is a diagram illustrating an example of a more detailed circuit configuration of the sense amplifier module included in the memory device according to the first embodiment.
FIG. 8 is a diagram illustrating an example of arrangement of the sense amplifier module and the data register included in the memory device according to the first embodiment.
FIG. 9 is a diagram illustrating an example of a circuit configuration of a driver circuit and a detection circuit included in the memory device according to the first embodiment.
FIG. 10 is a diagram illustrating an example of threshold voltage distribution of a memory cell transistor and data allocation in the memory device according to the first embodiment.
FIG. 11 is a diagram illustrating an example of combined threshold voltage distribution of NAND strings in the memory device according to the first embodiment.
FIG. 12 is a flowchart illustrating an example of a processing procedure of the read operation of the memory system according to the first embodiment.
FIG. 13 is a diagram illustrating an example of a voltage applied to the NAND strings at a certain time of a normal read operation of the memory device according to the first embodiment.
FIG. 14 is a diagram illustrating an example of an operation waveform of the normal read operation of the memory device according to the first embodiment.
FIG. 15 is a flowchart illustrating an example of a processing procedure of a correction read operation of the memory device according to the first embodiment.
FIG. 16 is a diagram illustrating an example of variation in combined threshold voltage distribution of NAND strings in the memory device according to the first embodiment.
FIG. 17 is a diagram illustrating an example of a voltage applied to the NAND strings at a certain time of the correction read operation of the memory device according to the first embodiment.
FIG. 18 is a diagram illustrating an example of an operation waveform of the correction read operation of the memory device according to the first embodiment.
FIG. 19 is a diagram illustrating an example of a command sequence of the correction read operation of the memory device according to the first embodiment.
FIG. 20 is a diagram illustrating an example of an operation waveform of an on-chip tracking operation in a comparative example.
FIG. 21 is a diagram illustrating an example of an operation waveform of the correction read operation according to a first further embodiment of the first embodiment.
FIG. 22 is a diagram illustrating an example of an operation waveform of the correction read operation according to a second further embodiment of the first embodiment.
FIG. 23 is a diagram illustrating an example of an operation waveform of the correction read operation according to a third further embodiment of the first embodiment.
FIG. 24 is a diagram illustrating an example of arrangement of bit lines selected at the time of detecting a combined threshold voltage distribution in a correction read operation of a memory device according to a second embodiment.
FIG. 25 is a diagram illustrating an example of an operation waveform of the correction read operation of the memory device according to the second embodiment.
FIG. 26 is a diagram illustrating an example of a state of a block included in a memory cell array included in a memory device according to a third embodiment.
FIG. 27 is a flowchart illustrating an example of a processing procedure of a correction read operation of a memory system according to the third embodiment.
FIG. 28 is a diagram illustrating an example of an operation waveform of the correction read operation of the memory device according to the third embodiment.
FIG. 29 is a diagram illustrating an example of a configuration of a block included in a memory cell array included in a memory device according to a fourth embodiment.
FIG. 30 is a diagram illustrating a first example of a state of a block that is a target of the correction read operation of the memory system according to the fourth embodiment.
FIG. 31 is a diagram illustrating a second example of a state of a block that is a target of the correction read operation of the memory system according to the fourth embodiment.
FIG. 32 is a diagram illustrating a third example of a state of a block that is a target of the correction read operation of the memory system according to the fourth embodiment.
FIG. 33 is a diagram illustrating a fourth example of a state of a block that is a target of the correction read operation of the memory system according to the fourth embodiment.
FIG. 34 is a diagram illustrating a fifth example of a state of a block that is a target of the correction read operation of the memory system according to the fourth embodiment.
FIG. 35 is a diagram illustrating a first example of the operation waveform of the correction read operation and the method of using the sense amplifier module of the memory system according to the fifth embodiment.
FIG. 36 is a diagram illustrating an example of a measurement target by three-point read of the memory system according to the fifth embodiment.
FIG. 37 is a diagram illustrating a second example of the operation waveform of the correction read operation and the method of using the sense amplifier module of the memory system according to the fifth embodiment.
FIG. 38 is a diagram illustrating an example of an operation waveform of the correction read operation according to a further embodiment of the fifth embodiment.
FIG. 39 is a block diagram illustrating an example of a hardware configuration of a memory device included in a memory system according to a sixth embodiment.
FIG. 40 is a diagram illustrating an example of a circuit configuration of a sense amplifier module and a detection circuit included in the memory device according to the sixth embodiment.
FIG. 41 is a flowchart illustrating an example of a processing procedure of a correction read operation of the memory device according to the sixth embodiment.
FIG. 42 is a diagram illustrating an example of an operation waveform of the correction read operation of the memory device according to the sixth embodiment.

### DETAILED DESCRIPTION

In general, according to one embodiment, a memory device includes a plurality of strings, a plurality of bit lines, a plurality of word lines, a source line, and a controller. Each of the strings includes a plurality of memory cells coupled in series. Each of the strings has one end coupled to different bit line among the bit lines. The plurality of word lines are respectively coupled to the memory cells in each of the strings. Each of the strings has the other end coupled to the source line. The controller is configured to execute a first read operation including a first read sequence and a second read sequence. The controller is further configured to: in the first read sequence, increase voltages of the word lines at the same speed, and determine a correction value of each of a plurality of read voltages based on a timing at which an amount of current through the strings changes with an increase in voltages of the word lines; and in the second read sequence, execute a read operation using the read voltages to which the correction value is applied.

Hereinafter, embodiments will be described with reference to the drawings. The embodiments will exemplify apparatuses and methods for embodying the technical idea of the invention. The drawings are schematic or conceptual. The illustration of the configuration is omitted as appropriate. Components having substantially the same functions and configurations are denoted by the same reference numerals. Numbers and the like added to reference numerals are referred to by the same reference numerals and are used to distinguish between similar components.

### <1> First Embodiment

The memory system MS according to the first embodiment determines, in the read operation, a suitable shift value of the read voltage based on the combined threshold voltage distribution of a plurality of memory cell transistors MT coupled in series in NAND strings NS. In the first embodiment, the bottom of the combined threshold voltage distribution of the plurality of memory cell transistors MT coupled in series in the NAND strings NS is detected using the change in the current flowing through a source line SL. Hereinafter, details of the memory system MS according to the first embodiment will be described.

### <1-1> Configuration

First, a configuration of the memory system MS according to the first embodiment will be described.

### <1-1-1> Configuration of Memory System MS

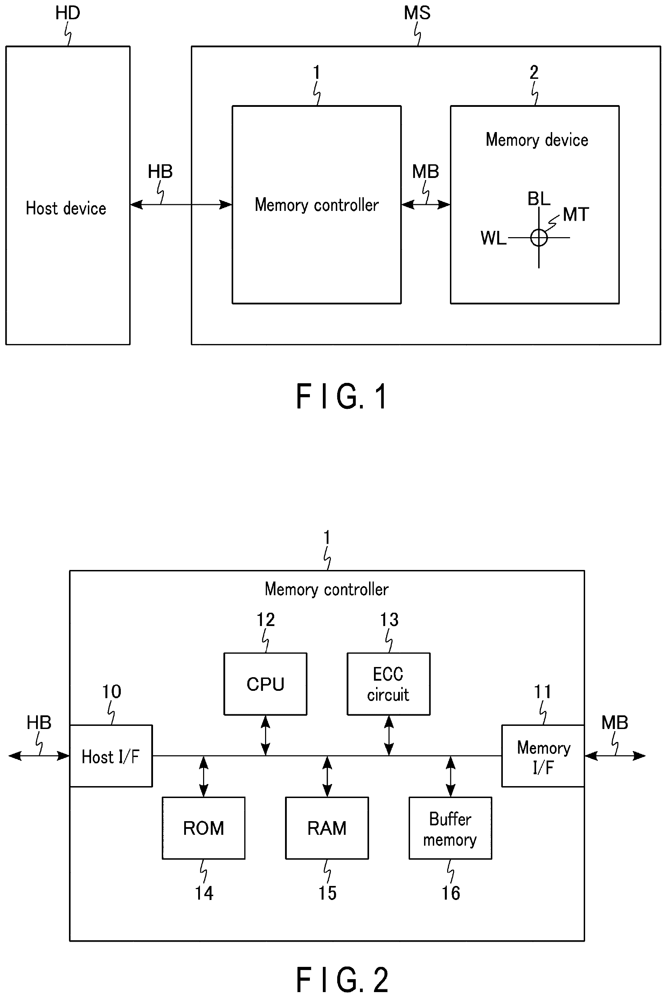

FIG. 1 is a block diagram illustrating an example of a configuration of the memory system MS according to the first embodiment. As illustrated in FIG. 1, the memory system MS can be coupled to an external host device HD (also referred to as a host). The host device HD is an electronic device, such as a personal computer, a personal digital assistant, or a server. The memory system MS is a storage device, such as a memory card or a solid state drive (SSD). The memory system MS includes, for example, a memory controller 1 and at least one memory device 2.

The memory controller 1 is, for example, a semiconductor integrated circuit configured as a system on a chip (SoC), an application specific integrated circuit (ASIC), or a field-programmable gate array (FPGA). The memory controller 1 has a function of managing and controlling the memory device 2. The memory controller 1 is coupled to the host device HD via a host bus HB. The memory controller 1 is coupled to the memory device 2 via a memory bus MB. The memory controller 1 can control the memory device 2 based on a command received from the host device HD. For example, the memory controller 1 can control the memory device 2 to execute a read operation, a write operation, an erase operation, and the like.

The memory device 2 is, for example, a semiconductor memory device configured to store data in a non-volatile manner. The memory device 2 is, for example, a NAND flash memory. In the NAND flash memory, a unit of a data read operation and a data write operation is referred to as a page. The memory device 2 includes a plurality of memory cell transistors MT, a plurality of bit lines BL, and a plurality of word lines WL. For example, each memory cell transistor MT is associated with one bit line BL and one word line WL. A column address is assigned to each of the bit lines BL. A page address is assigned to each of the word lines WL.

### <1-1-2> Hardware Configuration of Memory Controller 1

FIG. 2 is a block diagram illustrating an example of a hardware configuration of the memory controller 1 included in the memory system MS according to the first embodiment. As illustrated in FIG. 2, the memory controller 1 includes, for example, a host interface (host I/F) 10, a memory interface (memory I/F) 11, a central processing unit (CPU) 12, an error correction code (ECC) circuit 13, a read only memory (ROM) 14, a random access memory (RAM) 15, and a buffer memory 16. The host I/F 10, the memory I/F 11, the CPU 12, the ECC circuit 13, the ROM 14, the RAM 15, and the buffer memory 16 may be coupled to an internal bus.

The host I/F 10 controls communication conforming to an interface specification between the host device HD and the memory controller 1. The host I/F 10 is coupled to the host device HD via the host bus HB. The host I/F 10 supports an interface specification such as Serial Advanced Technology Attachment (SATA), Serial Attached SCSI (SAS), PCI Express (PCIe^{™}), and Non-Volatile Memory Express^{™} (NVMe^{™}).

The memory I/F 11 controls communication conforming to an interface specification between the memory controller 1 and the memory device 2. The memory I/F 11 is coupled to the memory device 2 via the memory bus MB. The memory I/F 11 supports an interface specification, such as Toggle DDR and Open NAND Flash Interface (ONFI).

The CPU 12 controls the overall operation of the memory controller 1. The CPU 12 instructs the memory device 2 to execute a data write operation via the memory I/F 11 in accordance with a write request received via the host I/F 10. The CPU 12 instructs the memory device 2 to execute a data read operation via the memory I/F 11 in accordance with a read request received via the host I/F 10.

The ECC circuit 13 is a circuit that executes ECC processing. The ECC processing includes data coding and decoding. The ECC circuit 13 encodes data to be written in the memory device 2, and decodes data read out from the memory device 2.

The ROM 14 is a non-volatile memory. The ROM 14 stores, for example, a program such as firmware. The ROM 14 is, for example, an electrically erasable programmable read-only memory (EEPROM^{™}). The CPU 12 executes various processing by executing firmware stored in the ROM 14 or the like.

The RAM 15 is a volatile memory. The RAM 15 is used as a work area of the CPU 12. The RAM 15 is, for example, a static random access memory (SRAM) or a dynamic random access memory (DRAM).

The buffer memory 16 is, for example, a volatile memory. The buffer memory 16 temporarily stores data received via the host I/F 10, data received via the memory I/F 11, or the like. The buffer memory 16 is, for example, a DRAM or an SRAM. The buffer memory 16 may be mounted on an outside of the memory controller 1.

### <1-1-3> Hardware Configuration of Memory Device 2

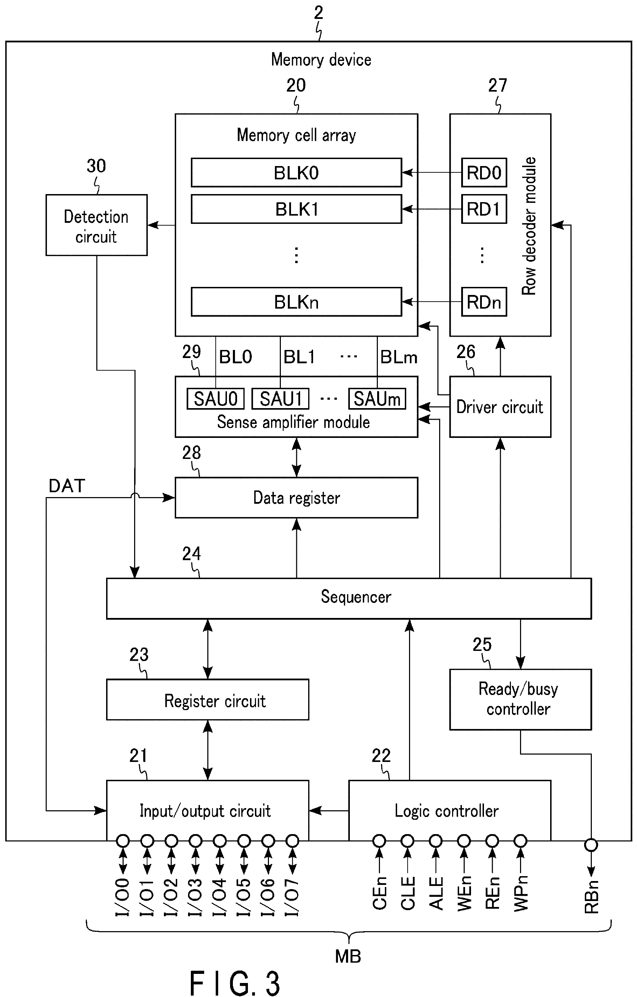

FIG. 3 is a block diagram illustrating an example of a configuration of the memory device 2 included in the memory system MS according to the first embodiment. As illustrated in FIG. 3, the memory device 2 includes, for example, a memory cell array 20, an input/output circuit 21, a logic controller 22, a register circuit 23, a sequencer 24, a ready/busy controller 25, a driver circuit 26, a row decoder module 27, a data register 28, a sense amplifier module 29, and a detection circuit 30. Signals transmitted and received between the memory device 2 and the memory controller 1 via the memory bus MB include, for example, input/output signals I/O0 to I/O7, control signals CEn, CLE, ALE, WEn, REn, and WPn, and a ready/busy signal RBn.

The memory cell array 20 is a set of the memory cell transistors MT. The memory cell array 20 includes a plurality of blocks BLKO to BLKn ("n" is an integer of 1 or larger). The block BLK is a management unit of a storage area of the memory device 2. The data erase operation is performed, for example, in units of blocks BLK. A block address is assigned to each of the blocks BLK. The memory cell array 20 is provided with a plurality of bit lines BL0 to BLm ("m" is an integer of 1 or larger) and a plurality of word lines WL (not illustrated).

The input/output circuit 21 controls transmission and reception (input/output) of the input/output signals I/O0 to I/O7. The input/output signal I/O can include, for example, data DAT, status information, an address, and a command. The input/output circuit 21 can input and output the data DAT between the data register 28 and the memory controller 1. The input/output circuit 21 can output the status information transferred from the register circuit 23 to the memory controller 1. The input/output circuit 21 can output each of the address and the command transferred from the memory controller 1 to the register circuit 23.

The logic controller 22 controls each of the input/output circuit 21 and the sequencer 24 based on various control signals input from the memory controller 1. The logic controller 22 enables the memory device 2 based on the control signal CEn. The logic controller 22 notifies the input/output circuit 21 that the input/output signals I/O received by the memory device 2 are the command and the address, respectively, based on the control signals CLE and ALE. The logic controller 22 instructs the input/output circuit 21 to receive the input/output signal I/O based on the control signal WEn, and instructs the input/output circuit 21 to transmit the input/output signal I/O based on the control signal REn. The logic controller 22 brings the memory device 2 into a protection state based on the control signal WPn.

The register circuit 23 temporarily may store a status, an address, a command, and the like. The status information is indicates an operation state of the memory device 2. The status information is updated based on the control of the sequencer 24 and transferred to the memory controller 1 via the input/output circuit 21. The address may include a block address, a page address, a column address, and the like. The commands include instructions relating to various operations of the memory device 2.

The sequencer 24 controls the overall operation of the memory device 2. The sequencer 24 can execute a read operation, a write operation, an erase operation, etc. based on the command and the address stored in the register circuit 23. Furthermore, in the read operation, the sequencer 24 can execute a correction read operation of selecting a suitable shift value (correction value) of the read voltage according to the state of the page to be read. Details of the correction read operation will be described later.

The ready/busy controller 25 can generate a ready/busy signal RBn under the control of the sequencer 24. The ready/busy signal RBn notifies the memory controller 1 whether the memory device 2 is in a ready state or a busy state. The ready state is a state in which the memory device 2 can accept a command from the memory controller 1, and notified by the ready/busy signal RBn at a high-level. The busy state is a state in which the memory device 2 cannot accept a command from the memory controller 1, and notified by the ready/busy signal RBn at a low-level.

The driver circuit 26 generates voltages for use in a read operation, a write operation, an erase operation, etc. Then, the driver circuit 26 supplies the generated voltages to the memory cell array 20, the row decoder module 27 and the sense amplifier module 29, and the like.

The row decoder module 27 is a circuit for use in selecting the block BLK and supplying a voltage to interconnects, such as the word line WL. The row decoder module 27 includes a plurality of row decoders RDO to RDn. The row decoders RD0 to RDn are associated with the blocks BLK0 to BLKn, respectively. Each of the row decoders RD can set the associated block BLK to be selected or unselected based on the block address.

The data register 28 may temporarily stores the data DAT. The data register 28 may be used, for example, when the data DAT is input and output between the input/output circuit 21 and the sense amplifier module 29. The data register 28 may be referred to as a data latch, a page register, or a cache memory.

The sense amplifier module 29 is a circuit for use in supplying a voltage to each bit line BL and reading data. The sense amplifier module 29 includes a plurality of sense amplifier units SAUO to SAUm. The sense amplifier units SAUO to SAUm are associated with a plurality of bit lines BL0 to BLm, respectively. Each of the sense amplifier units SAU may determine data read from the selected memory cell transistor MT based on the voltage of the associated bit line BL.

In the correction read operation, the detection circuit 30 detects the state of the page to be read based on a change in the current flowing in the memory cell array 20. Then, the detection circuit 30 outputs the detection result to the sequencer 24. The sequencer 24 may determine a shift amount of the read voltage used in the correction read operation based on the detection result.

Note that in the memory device 2, a set of the memory cell array 20, the row decoder module 27, and the sense amplifier module 29 may be referred to as a plane. The plane includes at least the memory cell array 20. The memory device 2 may include a plurality of planes. The sequencer 24 can be configured to be able to control each of the plurality of planes.

### <1-1-4> Circuit Configuration of Memory Cell Array 20

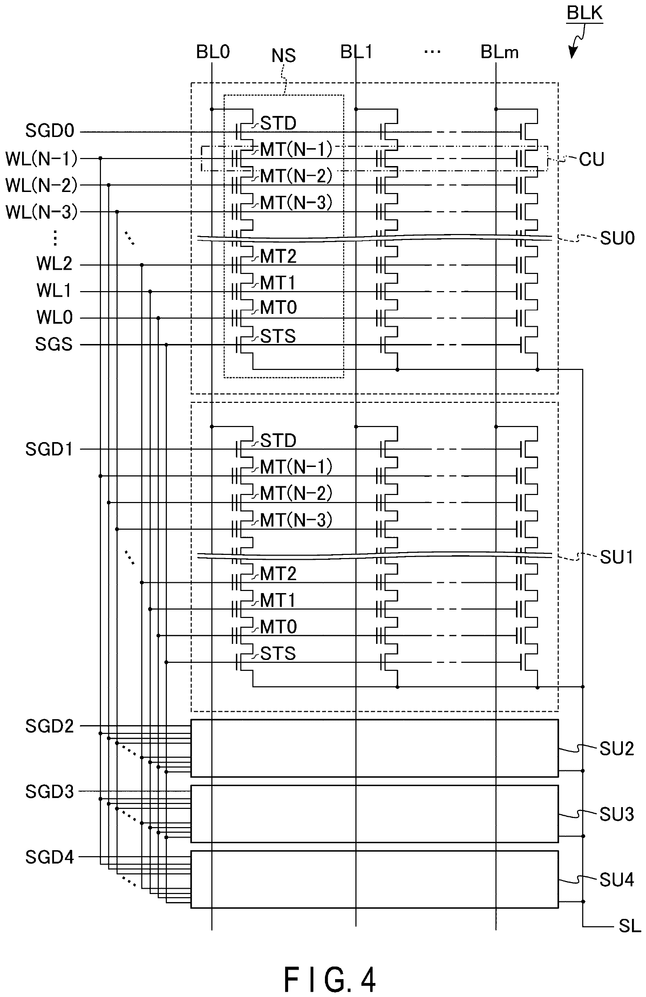

FIG. 4 is a diagram illustrating an example of a circuit configuration of the memory cell array 20 according to the first embodiment. In FIG. 4, one of the plurality of blocks BLK included in the memory cell array 20 is illustrated. As illustrated in FIG. 4, the block BLK is coupled to a plurality of bit lines BL0 to BLm, a plurality of word lines WL0 to WL (N-1) (N is an integer of two or larger), select gate lines SGDO to SGD4, a select gate line SGS, and a source line SL. The select gate lines SGDO to SGD4 and SGS and the word lines WLO to WL (N-1) (N is an integer of two or larger) are provided for each block BLK. The bit lines BL0 to BLm are shared by a plurality of blocks BLK. The source line SL is shared by a plurality of blocks BLK.

The block BLK includes, for example, five string units SU0 to SU4. Each string unit SU includes a plurality of NAND strings NS. The plurality of NAND strings NS are associated with the bit lines BLO to BLm, respectively. That is, each bit line BL is shared by the NAND string NS to which the same column address is assigned among the plurality of blocks BLK. Each NAND string NS is coupled between the associated bit line BL and the source line SL.

Each NAND string NS includes, for example, N memory cell transistors MT0 to MT (N-1) and select transistors STD and STS. Each memory cell transistor MT is a memory cell including a control gate and a charge storage layer, and holds (stores) data in a nonvolatile manner. The threshold voltage of the memory cell transistor MT can be changed based on the amount of charge injected into the charge storage layer or the like. Each of the select transistors STD and STS is used to select the block BLK and the string unit SU.

In each NAND string NS, the select transistor STD, the memory cell transistors MT (N-1) to MT0, and the select transistor STS are coupled in series in this order. Specifically, the drain of the select transistor STD is coupled to the associated bit line BL. The source of the select transistor STD is coupled to the drain of the memory cell transistor MT (N-1). The memory cell transistors MT0 to MT (N-1) are coupled in series between the select transistors STD and STS. The drain of the select transistor STS is coupled to the source of the memory cell transistor MT0. The source of the select transistor STS is coupled to the source line SL.

The select gate lines SGDO to SGD4 are associated with the string units SU0 to SU4, respectively. Each select gate line SGD is coupled to the gate of each of the plurality of select transistors STD included in the associated string unit SU. The select gate line SGS is coupled to the gate of each of the plurality of select transistors STS included in the associated block BLK. The word lines WLO to WL (N-1) are coupled to the control gates of the plurality of memory cell transistors MT0 to MT (N-1) included in the associated block BLK, respectively.

Note that in the memory cell array 20, the number of the string units SU included in each block BLK and the number of the select transistors STD and STS included in each NAND string NS can be designed to any numbers. The select gate line SGS may be provided for each string unit SU.

In the present specification, a set of the plurality of memory cell transistors MT coupled to the common word line WL in one string unit SU is referred to as a cell unit CU. In addition, a set of 1-bit data stored in each of the plurality of memory cell transistors MT included in the cell unit CU is referred to as page data. That is, the "page" is associated with a set of the memory cell transistors MT coupled to the common word line WL in the same block BLK. The cell unit CU can store two or more pages according to the number of bits of data stored in each memory cell transistor MT. That is, the memory controller 1 can manage the storage area of the memory device 2 in units of cell units CU configured by a plurality of memory cell transistors MT each of which can store a plurality of bit data.

### <1-1-5> Circuit Configuration of Row Decoder Module 27

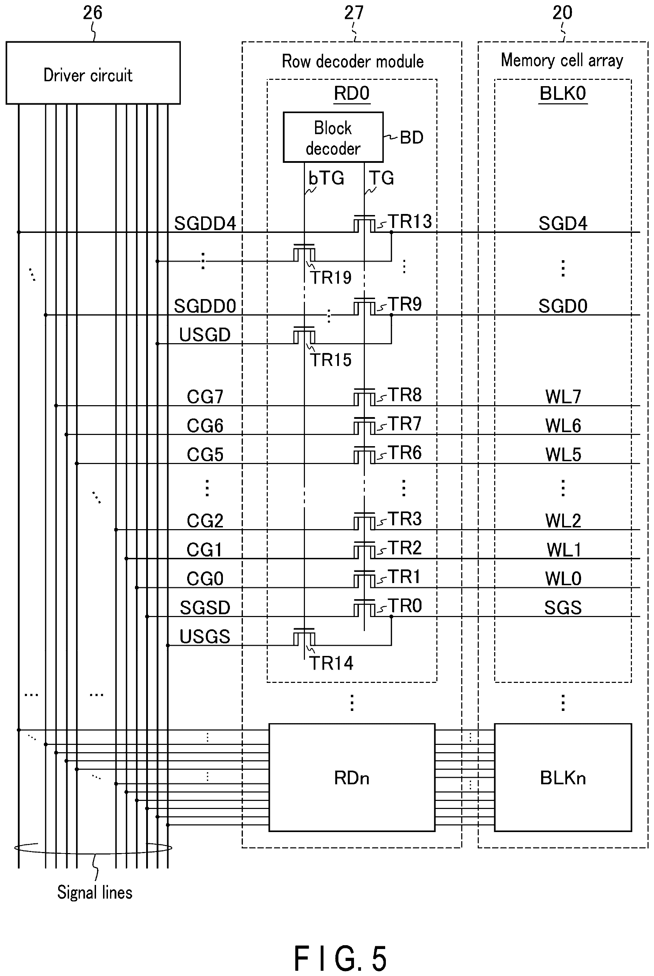

FIG. 5 is a diagram illustrating an example of a circuit configuration of the row decoder module 27 according to the first embodiment. In FIG. 5, a connectivity relationship between each of the driver circuit 26 and the memory cell array 20 and the row decoder module 27, and a detailed circuit configuration of the row decoder RDO corresponding to the block BLK0 are illustrated. The circuit configuration of the other row decoders RD is similar to that of the row decoder RD0. In FIG. 5, a case where the number of the word lines WL is eight is illustrated.

As illustrated in FIG. 5, each row decoder RD is coupled to signal lines CG0 to CG7, SGDDO to SGDD4, SGSD, USGD, and USGS coupled to the driver circuit 26. In addition, each row decoder RD is coupled to the word lines WLO to WL7 of the associated block BLK and the select gate lines SGDO to SGD4 and SGS.

The row decoder RDO includes, for example, transistors TR0 to TR19, transfer gate lines TG and bTG, and a block decoder BD. Each of the transistors TR0 to TR19 is an n-channel high-breakdown voltage MOS transistor. The transfer gate line TG is coupled to the gates of the transistors TR0 to TR13. The transfer gate line bTG is coupled to the gates of the transistors TR14 to TR19. The drains of the transistors TR0 to TR13 are coupled to the signal lines SGSD, CG0 to CG7, and SGDDO to SGDD4, respectively. Sources of the transistors TR0 to TR13 are coupled to the select gate line SGS, the word lines WLO to WL7, and the select gate lines SGDO to SGD4 of the block BLK0, respectively. The drain and the source of the transistor TR14 are coupled to the signal line USGS, and the select gate line SGS, respectively. The drains of the transistors TR15 to TR19 are coupled to the signal line USGD. Sources of the transistors TR15 to TR19 are coupled to the select gate lines SGDO to SGD4, respectively.

The block decoder BD decodes the block address, and applies a voltage based on the decoding result to the transfer gate line TG. For example, the block decoder BD applies one of a high level voltage and a low level voltage to the transfer gate line TG and applies the other of the high level voltage and the low level voltage to the transfer gate line bTG. Specifically, the block decoder BD of the selected block BLK applies a high-level voltage to the transfer gate line TG and applies a low-level voltage to the transfer gate line bTG. The block decoder BD of the unselected block BLK applies a low-level voltage to the transfer gate line TG and applies a high-level voltage to the transfer gate line bTG. As a result, the voltages of the signal lines CG0 to CG7 are applied to the word lines WL0 to WL7 of the selected block BLK, respectively, the voltages of the signal lines SGDDO to SGDD4 and SGSD are applied to the select gate lines SGDO to SGD4 and SGS of the selected block BLK, respectively, and the voltages of the signal lines USGD and USGS are applied to the select gate lines SGD and SGS of the unselected block BLK, respectively.

Note that the number of transistors TR included in the row decoder module 27 can be appropriately changed according to the number of interconnects of each block BLK. Since the signal line CG is shared by the plurality of blocks BLK, the signal line CG may be referred to as a global word line. Since the word line WL is provided for each block, it may be referred to as a local word line. Since each of the signal lines SGDD and SGSD is shared by the plurality of blocks BLK, the signal lines SGDD and SGSD may be referred to as global transfer gate lines. Each of the select gate lines SGD and SGS is provided for each block, and thus may be referred to as a local transfer gate line.

### <1-1-6> Configuration of Sense Amplifier Module 29 and Data Register 28

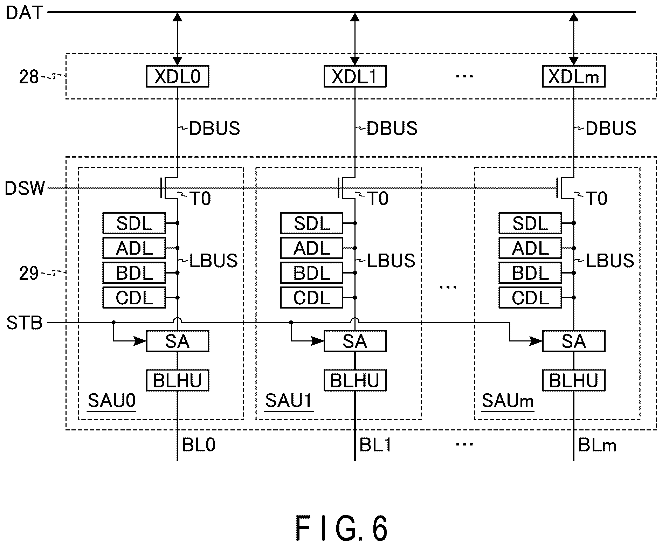

FIG. 6 is a diagram illustrating an example of a configuration of the sense amplifier module 29 and the data register 28 according to the first embodiment. As illustrated in FIG. 6, each sense amplifier unit SAU included in the sense amplifier module 29 includes, for example, a bit line connection section BLHU, a sense amplifier section SA, buses DBUS and LBUS, latch circuits SDL, ADL, BDL and CDL, and a transistor T0. The data register 28 includes a plurality of latch circuits XDL0 to XDLm.

Each of the latch circuits XDL can temporarily hold (store) data. The latch circuits XDLO to XDLm are associated with the sense amplifier units SAUO to SAUm, respectively. Each of the latch circuits XDL is configured to be able to transmit and receive data to and from the associated sense amplifier unit SAU via the bus DBUS. In addition, each of the latch circuits XDL is used for the input/output of data DAT between the sense amplifier module 29 and the input/output circuit 21. Each of the latch circuits XDL may be shared by a plurality of sense amplifier units SAU.

The bit line connection section BLHU is, for example, a protection circuit that prevents a high voltage applied to the channel of the NAND string NS in the erase operation from being applied to the sense amplifier section SA. The bit line connection section BLHU may be configured to be able to apply a predetermined voltage to the unselected bit lines BL.

The sense amplifier section SA is a circuit for use in determining data based on a voltage of the bit line BL and the applying of a voltage to the bit line BL. Each sense amplifier section SA is coupled to the associated bit line BL via the bit line connection section BLHU. When a control signal STB is asserted in a read operation, the sense amplifier section SA determines whether the data read from the selected memory cell transistor MT is "0" bit data or "1" bit data, based on the voltage of the associated bit line BL. The control signal STB is generated by, for example, the sequencer 24.

Each of the latch circuits SDL, ADL, BDL, and CDL can temporarily hold (store) data. The latch circuits SDL, ADL, BDL, and CDL and the sense amplifier section SA are configured to be able to transmit and receive data via the bus LBUS. In the data write operation, the sense amplifier unit SAU controls the bit line BL according to the data stored in the latch circuit SDL. The other latch circuits are used, for example, to temporarily store data of each bit when each memory cell transistor MT stores data of two bits or more. Note that the number of latch circuits can be arbitrarily set. The number of latch circuits is set according to the amount of data (the number of bits) that can be stored in the memory cell transistor MT, for example.

The transistor T0 controls transfer of a signal between the associated buses DBUS and LBUS. In other words, the transistor T0 is a bus switch for connecting the bus LBUS and the bus DUBS. One end of the transistor T0 of each sense amplifier unit SAU is coupled to the associated bus DBUS. The other end of the transistor T0 of each sense amplifier unit SAU is coupled to the associated bus LBUS. The control signal DSW is input to the gate of the transistor T0 of each sense amplifier unit. The control signals STB and DSW are generated by, for example, the sequencer 24.

### (1: More Detailed Circuit Configuration of Sense Amplifier Module 29)

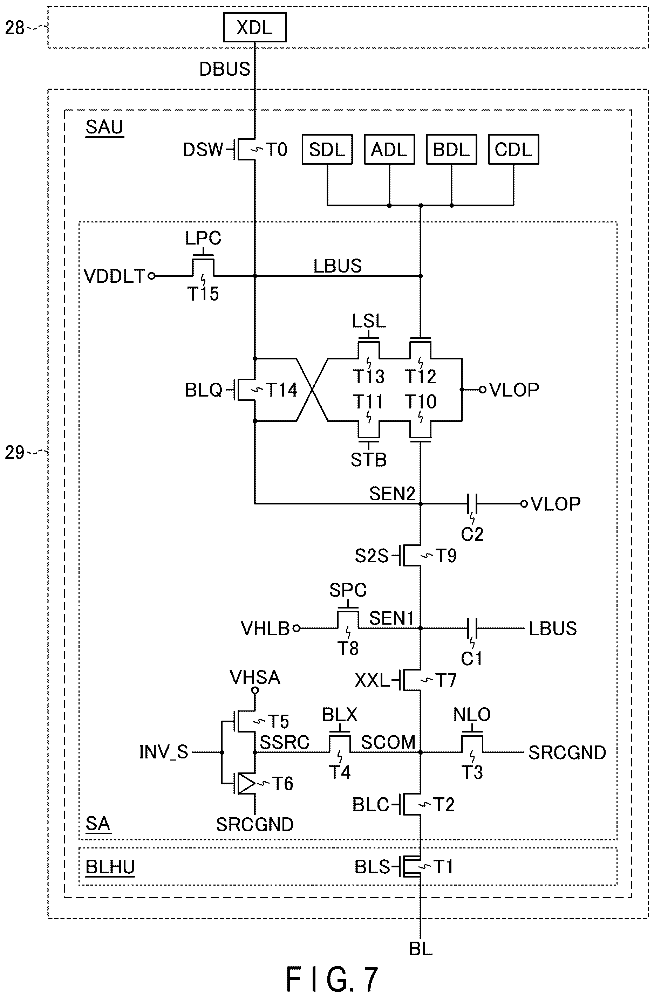

FIG. 7 is a diagram illustrating an example of a more detailed circuit configuration of the sense amplifier module 29 included in the memory device 2 according to the first embodiment. In FIG. 7, an extracted configuration related to one sense amplifier unit SAU among the plurality of sense amplifier units SAU included in the sense amplifier module 29 is illustrated. In the following description, one of the source and the drain of the transistor is referred to as "one end (of the current path)", and the other of the source and the drain is referred to as "the other end (of the current path)". The configuration assigned to one end and the other end (source or drain) may be different for each transistor.

As illustrated in FIG. 7, the bit line connection section BLHU includes, for example, a transistor T1. The sense amplifier section SA includes, for example, transistors T2 to T15, capacitance elements C1 and C2, and nodes SCOM, SSRC, SEN1, and SEN2. The transistor T1 is an n-channel high-breakdown voltage MOS transistor. Each of the transistors T2 to T5 and T7 to T15 is an n-channel low-breakdown voltage MOS transistor. The transistor T6 is an p-channel low-breakdown voltage MOS transistor.

One end of the transistor T1 is coupled to the bit line BL. The other end of the transistor T1 is coupled to one end of the transistor T2. The control signal BLS is input to the gate of the transistor T1. The other end of the transistor T2 is coupled to the node SCOM. The control signal BLC is input to the gate of the transistor T2. The transistor T2 can clamp the voltage of the indirectly coupled bit line BL to a voltage corresponding to the control signal BLC. One end of the transistor T3 is coupled to the node SCOM. The other end of the transistor T3 is coupled to a node SRCGND. For example, the ground voltage VSS is applied to the node SRCGND. A control signal NLO is input to the gate of the transistor T3. The transistor T2 is used for charging or discharging the indirectly coupled bit line BL.

One end of the transistor T4 is coupled to the node SCOM. The other end of the transistor T4 is coupled to a node SSRC. The control signal BLX is input to the gate of the transistor T4. One end of each of the transistors T5 and T6 is coupled to the node SSRC. For example, a voltage VHSA is applied to the other end of the transistor T5. The voltage VHSA is, for example, a voltage based on the power supply voltage VDD. The other end of the transistor T6 is coupled to a node SRCGND. The gates of the transistors T5 and T6 are coupled to a node INV_S. The node INV_S corresponds to a node used by the latch circuit SDL to hold data. As a result, one of the transistors T5 and T6 is turned on and the other is turned off according to the data held by the latch circuit SDL.

One end of the transistor T7 is coupled to the node SCOM. The other end of the transistor T7 is coupled to the node SEN1. A control signal XXL is input to the gate of the transistor T7. The transistor T7 is used to control a period in which data of the memory cell transistor MT is sensed. One end of the transistor T8 is coupled to the node SEN1. A voltage VHLB is applied to the other end of the transistor T7. The voltage VHLB is, for example, a voltage based on the power supply voltage VDD. The control signal SPC is input to the gate of the transistor T7. The transistor T8 can transfer the voltage VHLB applied to the other end and precharge the node SEN1 by being controlled to the on state by the control signal SPC.

One end of the transistor T9 is coupled to the node SEN1. The other end of the transistor T9 is coupled to the node SEN2. The control signal S2S is input to the gate of the transistor T9. The transistor T9 can electrically separate the nodes SEN1 and SEN2 by being controlled to the off state by the control signal S2S. The nodes SEN1 and SEN2 function as sense nodes for sensing data of the target memory cell transistor MT at the time of read. One electrode of the capacitance element C1 is coupled to the node SEN1. The other electrode of the capacitance element C1 is coupled to the bus LBUS. One electrode of the capacitance element C2 is coupled to the node SEN2. A voltage VLOP is applied to the other electrode of the capacitance element C2.

The gate of the transistor T10 is coupled to the node SEN2. The voltage VLOP is applied to one end of the transistor T10. The other end of the transistor T10 is coupled to one end of the transistor T11. The other end of the transistor T11 is coupled to the bus LBUS. The control signal STB is input to the gate of the transistor T11. The gate of the transistor T12 is coupled to the bus LBUS. The voltage VLOP is applied to one end of the transistor T12. The other end of the transistor T12 is coupled to one end of the transistor T13. The other end of the transistor T13 is coupled to the node SEN2. A control signal LSL is input to the gate of the transistor T13.

One end of the transistor T14 is coupled to the node SEN2. The other end of the transistor T14 is coupled to the bus LBUS. The control signal BLQ is input to the gate of the transistor T14. The transistor T14 can transfer the voltage based on the data between the bus LBUS and the node SEN2 by being controlled to the on state by the control signal BLQ. One end of the transistor T15 is coupled to the bus LBUS. A voltage VDDLT is applied to the other end of the transistor T15. The voltage VDDLT is, for example, a voltage lower than the voltage VHLB. The control signal LPC is input to the gate of the transistor T15, for example. The transistor T15 can transfer the voltage VDDLT applied to the other end and precharge the bus LBUS by being controlled to the on state by the control signal LPC.

In the read operation, for example, the charges precharged at the nodes SEN1 and SEN2 (the capacitance elements C1 and C2) are transferred to the bit line BL according to whether the target memory cell transistor MT is in the on state or the off state. Data is read by sensing the voltages of the nodes SEN1 and SEN2 at this time. In the following description, a set of the nodes SEN1 and SEN2 is also referred to as a sense node SEN.

Note that each of the control signals BLS, BLC, NLO, BLX, XXL, SPC, S2S, STB, LSL, BLQ, and LPC is generated by, for example, the sequencer 24. The sense amplifier module 29 may have a circuit configuration other than the above. The sense amplifier unit SAU includes at least one sense node. The sense amplifier unit SAU may include an operation circuit coupled to the bus LBUS and capable of executing various logic operations (AND operation, OR operation, and the like) using data stored in an internal latch circuit.

### (2: Arrangement of Sense Amplifier Module 29 and Data Register 28)

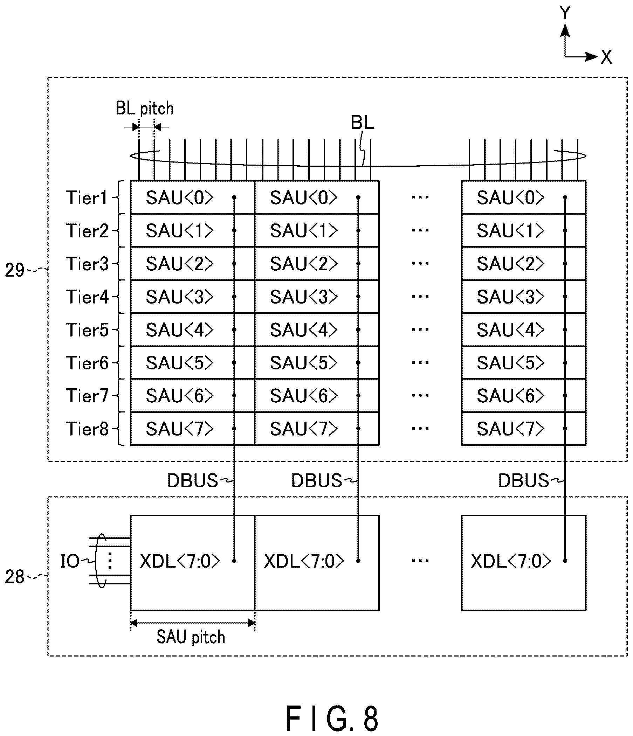

FIG. 8 is a diagram illustrating an example of arrangement of the sense amplifier module 29 and the data register 28 included in the memory device 2 according to the first embodiment. In FIG. 8, an arrangement of a plurality of sense amplifier units SAU included in the sense amplifier module 29 and an arrangement of a plurality of latch circuits XDL included in the data register 28 are illustrated. In the present specification, the X direction corresponds to the extending direction of the word line WL, and the Y direction corresponds to the extending direction of the bit line BL.

As illustrated in FIG. 8, in the sense amplifier module 29, for example, one bus DBUS is provided for every eight sense amplifier units SAU. The eight sense amplifier units SAU coupled to the common bus DBUS are arranged in the Y direction. In addition, a plurality of sets of the eight sense amplifier units SAU coupled to the common bus DBUS are arranged in the X direction. Note that the number of the sense amplifier units SAU coupled to the common bus DBUS may be another number. In the following description, the eight sense amplifier units SAU coupled to the common bus DBUS are denoted as SAU<0> to SAU<7>, respectively, to differentiate from each other. Further, a set of eight sense amplifier units SAU<0> to SAU<7> coupled to the common bus DBUS is referred to as a sense amplifier unit SAU<7:0>.

A latch circuit <7:0> associated with the sense amplifier unit SAU<7:0> is coupled to each bus DBUS. The eight latch circuits XDL<0> to XDL<7> are associated with the sense amplifier units SAU<0> to SAU<7>, respectively. That is, the numbers of the sense amplifier units SAU and the latch circuits XDL coupled to the common bus DBUS are designed to be equal to each other. The sense amplifier units SAU<7:0> and the latch circuit <7:0> coupled to the common bus DBUS are arranged in the Y direction. Note that each latch circuit XDL is coupled to a plurality of data lines IO coupled to the input/output circuit 21. For example, data received by the input/output circuit 21 from the memory controller 1 can be first stored in the latch circuit XDL via the data line IO and then transferred to the sense amplifier unit SAU via the bus DBUS. The same applies to the reverse process.

In FIG. 8, an interval between two bit lines BL adjacent to each other in the X direction is indicated as a "BL pitch". Further, a width in the X direction of a region where the sense amplifier unit SAU<7:0> is provided is indicated as an "SAU pitch". In other words, the SAU pitch corresponds to the width in the X direction of the region where a single sense amplifier unit SAU is provided. In this example, the width in the X direction of the region in which the eight bit lines BL are arranged is substantially equal to the SAU pitch.

In the present specification, a group of a plurality of sense amplifier units SAU<0> arranged in the X direction is referred to as "Tier 1". A group of a plurality of sense amplifier units SAU<1> arranged in the X direction is referred to as "Tier 2". A group of a plurality of sense amplifier units SAU<2> arranged in the X direction is referred to as "Tier 3". A group of a plurality of sense amplifier units SAU<3> arranged in the X direction is referred to as "Tier 4". A group of a plurality of sense amplifier units SAU<4> arranged in the X direction is referred to as "Tier 5". A group of a plurality of sense amplifier units SAU<5> arranged in the X direction is referred to as "Tier 6". A group of a plurality of sense amplifier units SAU<6> arranged in the X direction is referred to as "Tier 7". A group of a plurality of sense amplifier units SAU<7> arranged in the X direction is referred to as "Tier 8". The number of tiers can vary depending on the layout of the sense amplifier module 29 and the data register 28.

### <1-1-7> Circuit Configuration of Driver Circuit 26 and Detection Circuit 30

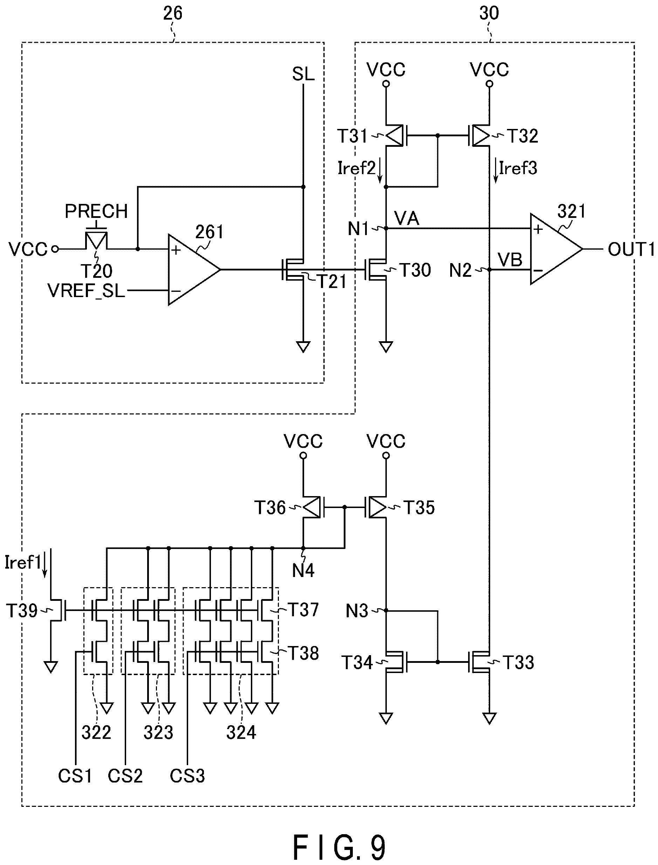

FIG. 9 is a diagram illustrating an example of a circuit configuration of the driver circuit 26 and the detection circuit 30 included in the memory device 2 according to the first embodiment. In FIG. 9, a configuration for applying a voltage to the source line SL in the driver circuit 26 is illustrated. As illustrated in FIG. 9, the driver circuit 26 includes, for example, transistors T20 and T21, and an error amplifier 261. The detection circuit 30 includes transistors T30 to T39, a comparator 321, and nodes N1 to N4. Each of the transistors T20, T31, T32, T35, and T36 is a p-channel MOS transistor. Each of the transistors T21, T30, T33, T34, T37, T38, and T39 is an n-channel MOS transistor.

The power supply voltage VCC is applied to one end of the transistor T20. The other end of the transistor T20 is coupled to the source line SL. A control signal PRECH is input to the gate of the transistor T20. The control signal PRECH is generated by, for example, the sequencer 24. The transistor T20 can transfer the power supply voltage VCC applied to one end and precharge the source line SL by being controlled to the on state by the control signal PRECH. One end of the transistor T21 is coupled to the source line SL. The other end of the transistor T21 is coupled to a ground node. A first input end of the error amplifier 261 is coupled to the source line SL. A voltage VREF_SL is applied to a second input end of the error amplifier 261. The output terminal of the error amplifier 261 is coupled to the gate of the transistor T21. The output voltage of the error amplifier 261 changes based on a voltage difference between the first input end and the second input end. The set of the transistor T21 and the error amplifier 621 functions as a linear regulator, and can maintain the voltage of the source line SL constant. The output voltage of the error amplifier 261 changes based on the amount of current flowing through the source line SL.

One end of the transistor T30 is coupled to the node N1. The other end of the transistor T30 is coupled to a ground node. The gate of the transistor T30 is coupled to the output terminal of the error amplifier 261. That is, the transistor T30 is controlled by the error amplifier 261 similarly to the transistor T21. Therefore, the amount of current flowing through the transistor T30 can change based on a change in the amount of current flowing through the source line SL. One end and the gate of the transistor T31 are coupled to the node N1. For example, the power supply voltage VCC is applied to the other end of the transistor T31. The gate of the transistor T32 is coupled to the node N1. One end of the transistor T32 is coupled to the node N2. The power supply voltage VCC is applied to the other end of the transistor T32, for example.

One end of the transistor T33 is coupled to the node N2. The other end of the transistor T33 is coupled to a ground node. The gate of the transistor T33 is coupled to the node N3. One end and the gate of the transistor T34 are coupled to the node N3. The other end of the transistor T34 is coupled to a ground node. One end of the transistor T35 is coupled to the node N3. The power supply voltage VCC is applied to the other end of the transistor T35, for example. The gate of the transistor T35 is coupled to the node N4. One end and the gate of the transistor T36 are coupled to the node N4. The power supply voltage VCC is applied to the other end of the transistor T36, for example.

A set of transistors T37 and T38 is coupled in series between the node N4 and the ground node. The detection circuit 30 may include a plurality of sets of such transistors T37 and T38. Specifically, the detection circuit 30 includes, for example, a reference current generation unit 322 including one set of transistors T37 and T38, a reference current generation unit 323 including two sets of transistors T37 and T38, and a reference current generation unit 324 including four sets of transistors T37 and T38. The gates of the transistors T37 are coupled to the gate of the transistor T39. The transistor T39 is controlled so that a reference current Iref1 flows in a correction read operation to be described later. A control signal CS1 is input to the gate of the transistor T38 included in the reference current generation unit 322. A control signal CS2 is input to the gates of the transistors T38 included in the reference current generation unit 323. A control signal CS3 is input to the gates of the transistors T38 included in the reference current generation unit 324. The control signals CS1 to CS3 are generated by, for example, the sequencer 24.

Here, a method of using the reference current generation units 322 to 324 will be described on the assumption that the sizes of the transistors T37 and T39 are the same. The sequencer 24 can set the current flowing through the node N4 to the reference current Iref1 by controlling only the control signal CS1 among the control signals CS1 to CS3 to the high level. The sequencer 24 can make the current flowing through the node N4 twice as much as the reference current Iref1 by controlling only the control signal CS2 among the control signals CS1 to CS3 to the high level. The sequencer 24 can make the current flowing through the node N4 four times as much as the reference current Iref1 by controlling only the control signal CS1 among the control signals CS1 to CS3 to the high level. In this manner, the sequencer can change the amount of current flowing through the node N4 by selectively using the reference current generation units 322 to 324.

The current flowing through the node N4 is mirrored to the node N3 by the transistors T35 and T36 constituting a current mirror circuit. The current flowing through the node N3 is mirrored to the node N2 by the transistors T33 and T34 constituting a current mirror circuit. The reference current Iref2 flowing through the node N1 is mirrored to the node N2 by the transistors T31 and T32 constituting a current mirror circuit. That is, the reference current Iref3 flowing through the node N2 is based on the reference currents Iref1 and Iref2.

The comparator 321 outputs a comparison result between a voltage VA at the node N1 and a voltage VB at the node N2 as an output signal OUT1. For example, when the amount of current flowing through the source line SL increases, the gate voltage of the transistor T30 increases, and the voltage VA of the node N1 increases. On the other hand, the voltage VB at the node N2 is maintained constant based on the reference current Iref1. As a result, for example, the comparator 321 can detect that the voltage VA exceeds the voltage VB and reflect the change in the current of the source line SL in the output signal OUT1. Note that the detection circuit 30 may have another circuit configuration as long as it can detect a change in the current of the source line SL.

### <1-1-8> Threshold Voltage Distribution of Memory Cell Transistor MT

Hereinafter, an example of the threshold voltage distribution of the memory cell transistor MT will be described. In the present specification, a case where 3-bit data is stored in each memory cell transistor MT, that is, a case of 3-bit/cell will be described as an example. The system for storing 3-bit data in the memory cell transistor MT is also referred to as a triple-level cell (TLC) system.

### (1: Threshold Voltage Distribution of Memory Cell Transistor MT in 3-bit/cell)

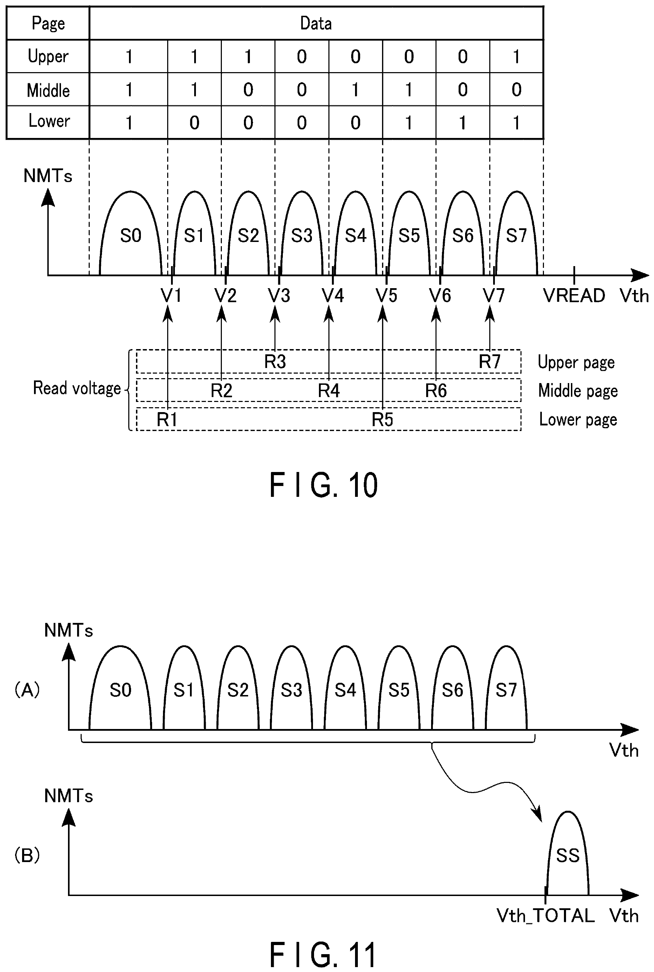

FIG. 10 is a diagram illustrating an example of threshold voltage distribution of the memory cell transistor MT and data allocation in the memory device 2 according to the first embodiment. The horizontal axis of the threshold voltage distribution illustrated in FIG. 10 corresponds to the threshold voltage (Vth) of the memory cell transistor MT. The horizontal axis of the threshold voltage distribution illustrated in FIG. 10 corresponds to the number of the memory cell transistors MT (NMTs). As illustrated in FIG. 10, the threshold voltage distribution of the memory cell transistor MT includes a plurality of states. Since randomization is performed on the data written in each cell unit CU, the memory cell transistors MT are substantially evenly distributed in the plurality of formed states. Then, the number of states in the threshold voltage distribution changes according to the number of bits of data stored in each of the plurality of memory cell transistors MT included in the cell unit CU.

In a case where the memory cell transistor MT stores 3-bit data, the threshold voltage distribution of the memory cell transistor MT has eight states. In the present specification, the eight states are referred to as states S0 to S7 in order from a lower threshold voltage. Three-bit data different from each other is allocated to each of the eight states S0 to S7. The threshold voltage of the memory cell transistor MT in the erase state is distributed to the state S0.

In the present specification, the 3-bit data stored in each memory cell transistor MT is also referred to as upper bit data, middle bit data, and lower bit data. One-page data configured by upper bit data, middle bit data, and lower bit data stored in each of the plurality of memory cell transistors MT included in each cell unit CU is also referred to as upper page data, middle page data, and lower page data, respectively. Hereinafter, an example of data allocated to the eight states S0 to S7 will be described.

### (Example) State name: "Upper bits/middle bits/lower bits" Data

State S0: "111" data
State S1: "110" data
State S2: "100" data
State S3: "000" data
State S4: "010" data
State S5: "O11" data
State S6: "001" data
State S7: "101" data.

A verify voltage and a read voltage are set between two adjacent states. In a write operation, the memory device 2 repeatedly executes a set of a program operation for increasing the threshold voltage of the memory cell transistor MT and a read operation using the verify voltage. The memory device 2 can determine whether the threshold voltage of the memory cell transistor MT targeted by the program has reached the target state based on the verify voltage. Furthermore, in the read operation, the memory device 2 executes the read operation using at least one read voltage. The memory device 2 can specify a state corresponding to the threshold voltage of the memory cell transistor MT based on whether or not the memory cell transistor MT to which the read voltage is applied is turned on.

In the TLC system, the verify voltages V1 to V7 are set in association with states S1 to S7, respectively. The read voltage R1 is set between the states S0 and S1. Similarly, the read voltages R2 to R7 are set between the states S1 and S2, between the states S2 and S3, between the states S3 and S4, between the states S4 and S5, between the states S5 and S6, and between the states S6 and S7, respectively. A read path voltage VREAD is set to a voltage higher than that of the state having the highest threshold voltage (for example, state S7). The read voltage is also referred to as a read level.

In a case where the data allocation illustrated in FIG. 7 is applied, the lower page data is determined by the read operation using the read voltages R1 and R5. The middle page data is determined by the read operation using the read voltages R2, R4, and R6. The upper page data is determined by the read operation using the read voltages R3 and R7. In the page data read operation using a plurality of read voltages, arithmetic processing is executed as needed in the sense amplifier unit SAU. Hereinafter, a series of operations of sensing data using one read voltage is also referred to as "read processing". That is, the read operation may include a plurality processes of read processing.

Note that data of one bit, two bits, or four bits or more may be stored in each memory cell transistor MT. In a case where the memory cell transistor MT stores k bit data (k is an integer of 1 or larger), the threshold voltage distribution of the memory cell transistor MT includes at least 2^{k} states. In other words, in a case where the memory cell transistor MT stores 4-bit data (four bits/cell), the threshold voltage distribution of the memory cell transistor MT has 16 states. In four bits/cell, 4-bit data different from each other is allocated to each of the 16 states. The system for storing 4-bit data in the memory cell transistor MT is also referred to as a Quad-level cell (QLC) system.

### (2: Combined Threshold Voltage Distribution of NAND Strings NS)

FIG. 11 is a diagram illustrating an example of combined threshold voltage distribution of NAND strings NS in the memory device 2 according to the first embodiment. In (A) of FIG. 11, the threshold voltage distribution of the TLC system in FIG. 10 is illustrated. In (B) of FIG. 11, the combined threshold voltage distribution of the NAND strings NS is illustrated. As described above, each NAND string NS includes, for example, N memory cell transistors MT0 to MT (N-1). In a case where the threshold voltage distribution of the memory cell transistor MT is randomized, at least one of the memory cell transistors MT0 to MT (N-1) included in each NAND string NS stochastically enters the state S7. Therefore, if each NAND string NS is virtually regarded as one memory cell transistor, the threshold voltage of the virtual memory cell transistor becomes higher than that of state S7. Therefore, the threshold voltage distribution in a case where the same potential is supplied to all the word lines WL and each NAND string NS is operated as one virtual memory cell transistor looks like, for example, the threshold voltage distribution as illustrated in (B) of FIG. 11. In the present specification, such a threshold voltage distribution is referred to as a combined threshold voltage distribution. Hereinafter, one state included in the combined threshold voltage distribution is referred to as a combined state SS. Furthermore, the lower limit voltage of the threshold voltage of the combined state SS is referred to as a combined threshold Vth_TOTAL.

If the voltages of all the word lines WL coupled to the NAND strings NS increase and become equal to or greater than the combined threshold Vth_TOTAL, the amount of current flowing through the NAND strings NS increases. On the other hand, if the voltages of all the word lines WL coupled to the NAND strings NS drop and become less than the combined threshold Vth_TOTAL, the current flowing through the NAND strings NS is cut off and becomes about the leakage current. The current amount if the voltages of all the word lines WL coupled to the NAND strings NS are equal to or greater than the combined threshold Vth_TOTAL is clearly larger than the leakage current. The combined threshold voltage distribution appears as one combined state SS in any case where the memory cell transistor MT stores k bit data (k is an integer of 1 or larger).

The combined state SS corresponds to the state S7 in the case of the TLC system. Then, the variation in the combined state SS is suppressed by being combined. As a result, the combined state SS is distributed narrower than the state having the highest threshold voltage (for example, the state S7) and is shifted upward. Therefore, the shift state of the threshold voltage distribution due to data retention can be estimated with high accuracy by detecting the bottom of the combined state SS. Furthermore, a shift amount of the threshold voltage distribution of each state can be estimated based on a shift amount at the bottom of the combined threshold voltage distribution. Then, the detection circuit 30 included in the memory device 2 according to the first embodiment is configured to be able to detect the bottom of the combined state SS based on a change in the source line SL current.

### <1-2> Operation

Next, an operation of the memory system MS according to the first embodiment will be described.

### <1-2-1> Processing Procedure of Read Operation

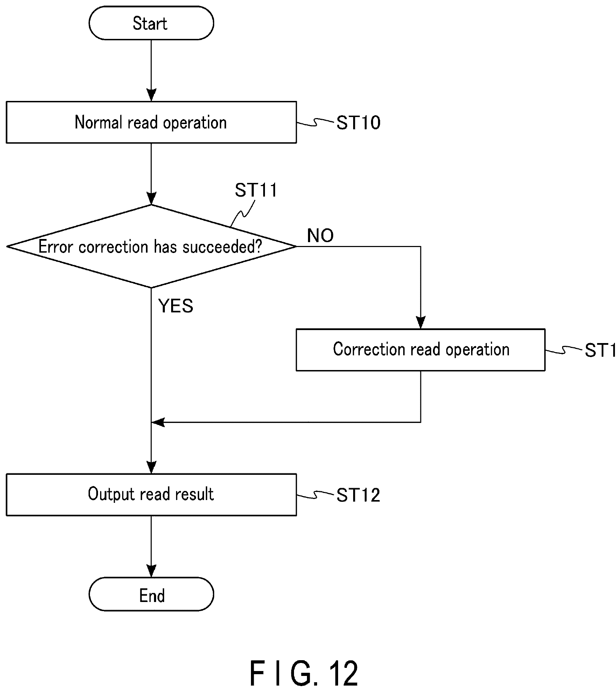

FIG. 12 is a flowchart illustrating an example of a processing procedure of the read operation of the memory system MS according to the first embodiment. For example, upon receiving a command to read data from the host device HD, the memory system MS starts a series of processing in FIG. 12 (start).

First, the memory system MS executes a normal read operation (step ST10). The normal read operation is a read operation using a preset read voltage. In the normal read operation, first, the memory controller 1 transmits a read command and address information to be read to the memory device 2 based on a command from the host device HD. Then, the memory device 2 executes a read operation based on the read command and the address information received from the memory controller 1, and transmits a read result to the memory controller 1. The read voltage used in the normal read operation may be a default value or a value shifted from the default value.

Then, the memory system MS determines whether or not error correction has succeeded in the read result obtained by the normal read operation (step ST11). In a case where the error correction has succeeded (step ST11: YES), the memory controller 1 outputs the read result to the host device HD (step ST12), and ends the series of processing of FIG. 12 (end). On the other hand, in a case where the error correction fails (step ST11: NO), the memory controller 1 executes a correction read result (step ST13). In this example, it is assumed that the error correction has succeeded in the error correction processing on a read result by the correction read operation. When the correction read operation is completed, the memory controller 1 outputs the read result to the host device HD (step ST12), and ends the series of processing of FIG. 12 (end) .

### <1-2-2> Normal Read Operation

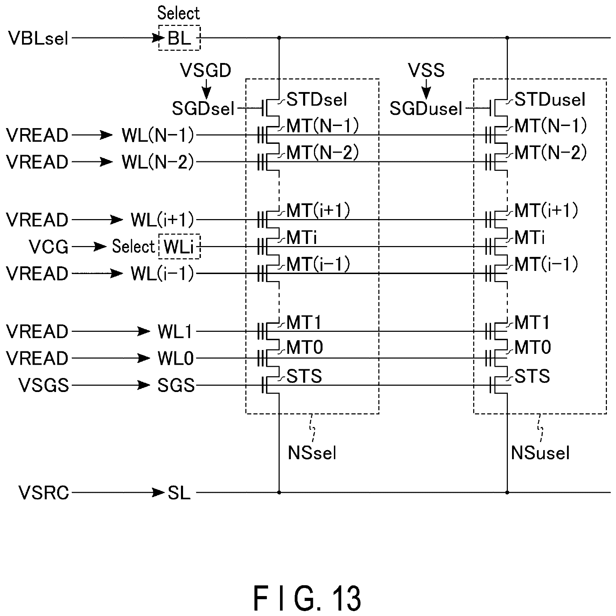

FIG. 13 is a diagram illustrating an example of a voltage applied to the NAND strings NS at a certain time of a normal read operation of the memory device 2 according to the first embodiment. In FIG. 13, two NAND strings NS, which are coupled to the common bit line BL and correspond to the selected and unselected string units, respectively, are extracted to be illustrated. The selected string unit corresponds to the string unit SU, including the cell unit CU to be read. The unselected string unit corresponds to the string unit SU, not including the cell unit CU to be read. In this example, the word line WLi (i is 0 or larger and (N-1) or less) is selected.

Hereinafter, the word line WL coupled to the cell unit CU to be read in the selected block BLK is referred to as a "selected word line WLsel". The word lines WL other than the selected word line WLsel in the selected block BLK are referred to as "unselected word lines WLusel". The NAND string NS included in the selected string unit is referred to as a "selected NAND string NSsel". The NAND string NS included in the unselected string unit is referred to as a "unselected NAND string NSusel". The select gate line SGD coupled to the selected string unit is referred to as a "select gate line SGDsel". The select gate line SGD included in the unselected string unit is referred to as a "select gate line SGDusel". The select transistor STD coupled to the select gate line SGDsel is referred to as a "select transistor STDsel". The select transistor STD coupled to the select gate line SGDusel is referred to as a "select transistor STDusel". The memory cell transistor MT included in the cell unit CU to be read is referred to as a "selected memory cell transistor MTsel".

As illustrated in FIG. 13, a voltage VBLsel higher than the ground voltage VSS is applied to the selected bit line BL at a certain time during the normal read operation. A voltage VSRC higher than the ground voltage VSS is applied to the source line SL. The read voltage VCG is applied to the selected word line WLsel (for example, the word line WLi). The read voltage VCG corresponds to, for example, any of the read voltages R1 to R7 illustrated in FIG. 10. The read path voltage VREAD is applied to the unselected word line WLusel (for example, the word line WLO). A voltage VSGD higher than the ground voltage VSS is applied to the select gate line SGDsel. For example, the ground voltage VSS is applied to the select gate line SGDusel. A voltage VSGS higher than the ground voltage VSS is applied to the select gate line SGS.

As a result, each of the select transistor STDsel coupled to the select gate line SGDsel and the select transistor STS coupled to the select gate line SGS can be turned on. As a result, the sense amplifier unit SAU can determine whether the threshold voltage of the selected memory cell transistor MTsel exceeds the read voltage VCG by determining whether a current has flowed between the bit line BL and the source line SL in the selected NAND string NSsel. The memory controller 1 can acquire the threshold voltage distribution in the cell unit CU to be read by using a plurality of types of read voltages VCG.

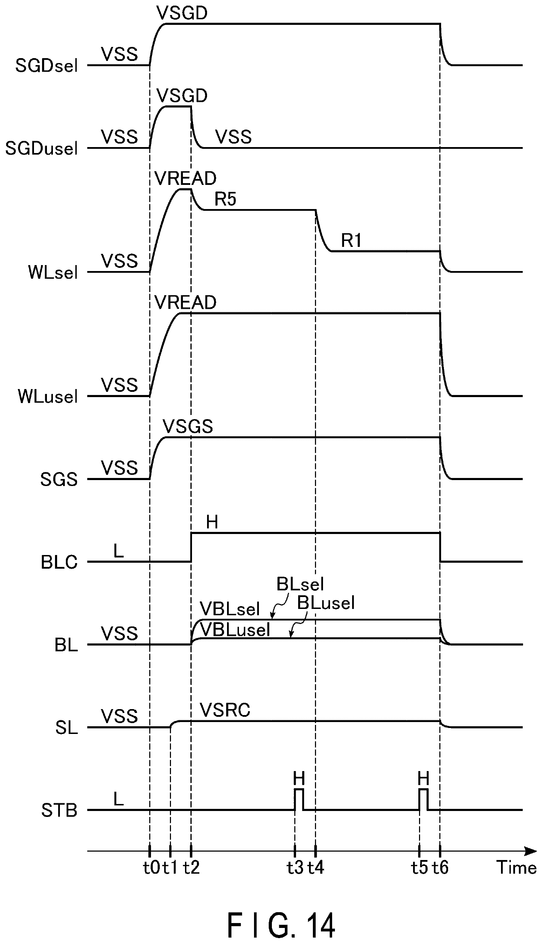

FIG. 14 is a diagram illustrating an example of an operation waveform of the normal read operation of the memory device 2 according to the first embodiment. In FIG. 14, changes in the voltages of the select gate line SGDsel, the select gate line SGDusel, the select word line WLsel, the unselected word line WLusel, the select gate line SGS, the control signal BLC, the bit line BL, the source line SL, and the control signal STB in the normal read operation for the lower page are illustrated. As illustrated in FIG. 14, in the normal read operation for the lower page data, the sequencer 24 sequentially executes the processing at times t0 to t6. At the start of the normal read operation, the voltage applied to each interconnect is the ground voltage VSS, and each control signal is at a low level ("L").

At time t0, the sequencer 24 applies the voltage VSGD to each of the select gate lines SGDsel and SGDusel, applies the voltage VSGS to the select gate line SGS, and applies the read path voltage VREAD to each of the select word line WLsel and the unselected word line WLusel. As described above, the voltage VSGD is applied to the select gate line SGDusel in a rising period of the word line WL, and the unselected select transistor STD is controlled to the on state. As a result, the read disturb caused by hot carriers in the unselected NAND string NSusel can be suppressed.

At time t1, the sequencer 24 applies the voltage VSRC to the source line SL. In the read operation of a first embodiment, a negative voltage can be applied to the selected memory cell transistor MTsel by applying the voltage VSRC to the source line SL. For example, in a case where the read voltage R1 is lower than the voltage VSRC, a negative voltage is applied to the selected memory cell transistor MTsel. Such read processing is also referred to as negative sensing.

At time t2, the sequencer 24 sets the control signal BLC to the high level ("H"). Then, the sense amplifier unit SAU coupled to the selected bit line BLsel charges the selected bit line BLsel, and the voltage of the selected bit line BLsel rises to the voltage VBLsel. Similarly, the sense amplifier unit SAU coupled to the unselected bit line BLusel charges the unselected bit line BLusel, and the voltage of the unselected bit line BLusel rises to the voltage VBLusel. Note that the unselected bit line BLusel is not necessarily charged at time t2, and the voltage of the voltage VBLusel may be controlled to maintain the ground voltage VSS. Further, at time t2, the sequencer 24 applies the ground voltage VSS to the select gate line SGDusel and applies the read voltage R5 to the selected word line WLsel. At this time, the sequencer 24 directly changes the read path voltage VREAD to a read voltage R5c without lowering the voltage to the ground voltage VSS. Then, the selected memory cell transistor MTsel to which the read voltage R5 is applied is turned on or off according to the data stored therein.

Although not illustrated, between time t2 and time t3, the sequencer 24 charges the sense node SEN of each sense amplifier unit SAU by setting the control signal SPC to a high level for a predetermined period. Then, the sequencer 24 sets the control signals XXL and S2S to the high level. Then, the voltage of the sense node SEN of each sense amplifier unit SAU is discharged or maintained according to the state of the selected memory cell transistor MTsel associated with the sense amplifier unit SAU.

At time t3, the sequencer 24 sets the control signal STB to the high level in a predetermined time. That is, at time t3, the sequencer 24 asserts the control signal STB. Then, the transistor T10 of each sense amplifier unit SAU is turned on or off according to the voltage of the sense node SEN of the sense amplifier unit SAU. As a result, a read result using the read voltage R5 is reflected on the bus LBUS, and the read result using the read voltage R5 is stored in a predetermined latch circuit.

The operations at times t4 and t5 are similar to the operation in which the voltage applied to the selected word line WLsel is changed from the read voltage R5 to the read voltage R1 in the operations described at times t2 and t3, respectively. Briefly, at time t4, the sequencer 24 applies the read voltage R1 to the word line WLsel. Then, at time t5, the sequencer 24 asserts the control signal STB. As a result, a read result using the read voltage R1 is reflected on the bus LBUS, and the read result using the read voltage R1 is stored in a predetermined latch circuit.

At time t6, the sequencer 24 changes the voltage applied to each interconnect and the voltage of each control signal to the state at the start of the normal read operation. Then, the sequencer 24 determines the lower bit data based on the read result using the read voltage R1 and the read result using the read voltage R5. Thereafter, the memory device 2 transmits the determined set of lower bit data as lower page data to the memory controller 1, and ends the normal line read operation for the lower page data.

Note that the memory device 2 can execute the normal read operation in which another page is selected, similarly to the read operation for the lower page data, by changing the read voltage and the arithmetic processing for data determination. In the present example, the case where the read result of each read processing is held in different latch circuits has been exemplified, but the present invention is not limited thereto. The sense amplifier unit SAU may reflect the read result of the consecutive read processing in one latch circuit (for example, the latch circuit SDL).

### <1-2-3> Correction Read Operation

Hereinafter, details of the correction read operation of the memory system MS according to the first embodiment will be described.

### (1: Processing Procedure of Correction Read Operation)

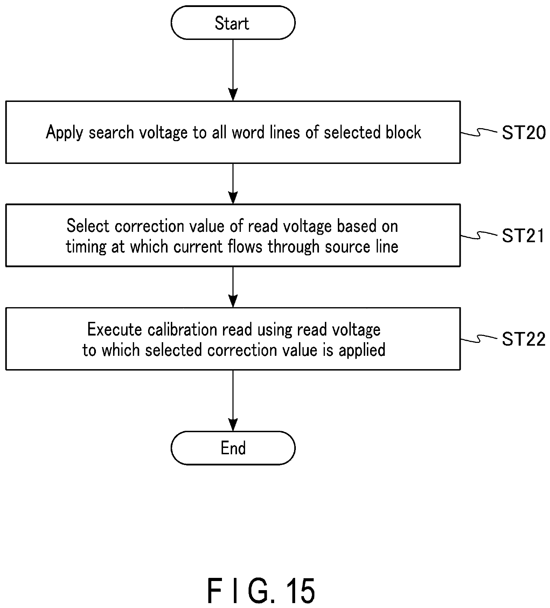

FIG. 15 is a flowchart illustrating an example of a processing procedure of a correction read operation of the memory device 2 according to the first embodiment. Upon receiving the instruction to execute the correction read operation from the memory controller 1, the memory device 2 starts a series of processing of FIG. 15 (start).

First, the memory device 2 applies a search voltage VLUMP to all the word lines WL of the selected block BLKsel (step ST20). The search voltage VLUMP is, for example, the same voltage as the read path voltage VREAD. The speed at which the search voltage VLUMP is applied to all the word lines WL may be different from the speed at which the read path voltage VREAD is applied to the unselected word line WLusel in the normal read operation.

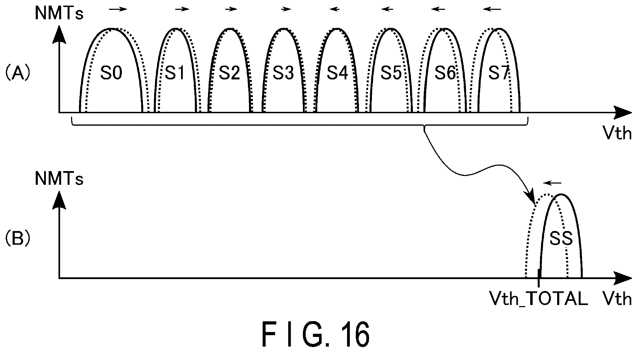

Next, the memory device 2 selects a correction value of the read voltage based on the timing at which the current flows through the source line SL (step ST21). In a case where the voltage supplied to all the word lines WL of the selected block BLKsel is increased from the ground voltage VSS toward the search voltage VLUMP, a current flows through the source line SL at timing when the voltage supplied to the word line WL reaches the combined threshold Vth_TOTAL of each NAND string NS. Therefore, the timing at which the current flows through the source line SL based on the combined threshold voltage distribution. As illustrated in FIG. 16, the combined threshold voltage distribution corresponds to individual threshold voltage distributions, and if another threshold voltage distribution fluctuates, the combined threshold voltage distribution also fluctuates correspondingly. Therefore, the combined threshold voltage distribution can be estimated by the timing at which the current flows through the source line SL, whereby the individual combined threshold voltage distribution can be estimated. A plurality of sets of correction values of the read voltage are prepared in association with each timing at which the current flows through the source line SL. In addition, the plurality of sets of correction values of the read voltage are stored in an area that can be referred to by the sequencer 24 during the correction read operation. The processing of steps ST20 and ST21 may be referred to as "search read".

Next, the memory device 2 executes a calibration read using the read voltage to which the selected correction value is applied (step ST22). The calibration read is read processing using the read voltage to which the selected correction value is applied. The calibration read may be referred to as "optimum value read". When the calibration read is completed, the memory device 2 outputs the read result to the memory controller 1 and ends the series of processing of FIG. 15 (end). Note that, in the present specification, the read voltage to which the correction value is applied may be referred to as a "suitable read voltage".

### (2: Example of Voltage Applied in Correction Read Operation)

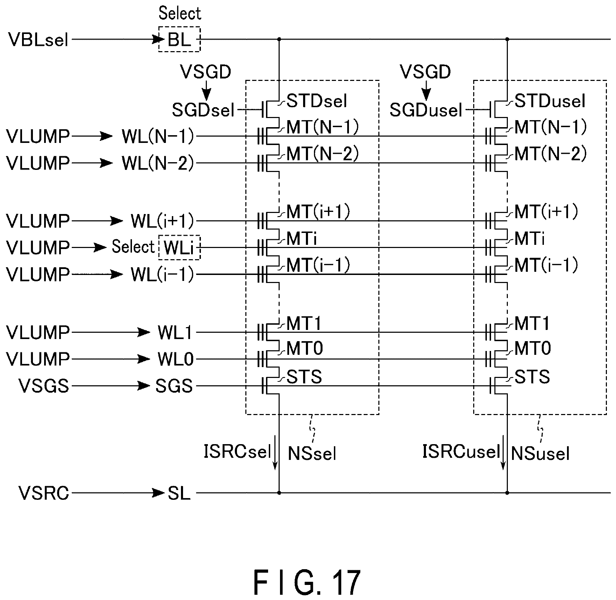

FIG. 17 is a diagram illustrating an example of a voltage applied to the NAND strings NS at a certain time of the correction read operation of the memory device 2 according to the first embodiment. In FIG. 17, selected NAND strings NSsel and unselected NAND strings NSusel coupled to a common bit line BL are extracted to be illustrated. In this example, the word line WLi is selected.

As illustrated in FIG. 17, a voltage VBLsel is applied to the selected bit line BL at a certain time during the correction read operation. The high voltage VSRC is applied to the source line SL. The search voltage VLUMP is applied to all the word lines WL including the selected word line WLsel. The voltage VSGD is applied to each of the select gate lines SGDsel and SGDusel. The voltage VSGS is applied to the select gate line SGS.

As a result, each of the select transistors STDsel and STDusel and the select transistor STS can be turned on. When the voltage of each word line WL increases toward the search voltage VLUMP, a current ISRCsel flows through the selected NAND string NSsel and a current ISRCusel flows through the unselected NAND string NSusel at a timing corresponding to the combined threshold voltage distribution (combined state SS) of all the NAND strings NS in the block BLK. Specifically, a portion where the current of the source line SL has changed corresponds to the bottom of the combined threshold voltage distribution of all the NAND strings NS in the block BLK. That is, the combined threshold voltage distribution of the block BLK including the cell unit CU to be read can be acquired based on the timing at which the current of the source line SL changes. As described above, the detection circuit 30 can acquire the combined threshold voltage distribution of the block BLK including the cell unit CU to be read based on the change in the total current of ISRCsel and ISRCusel (total Icell).

### (3: Operation Waveform of Correction Read Operation)

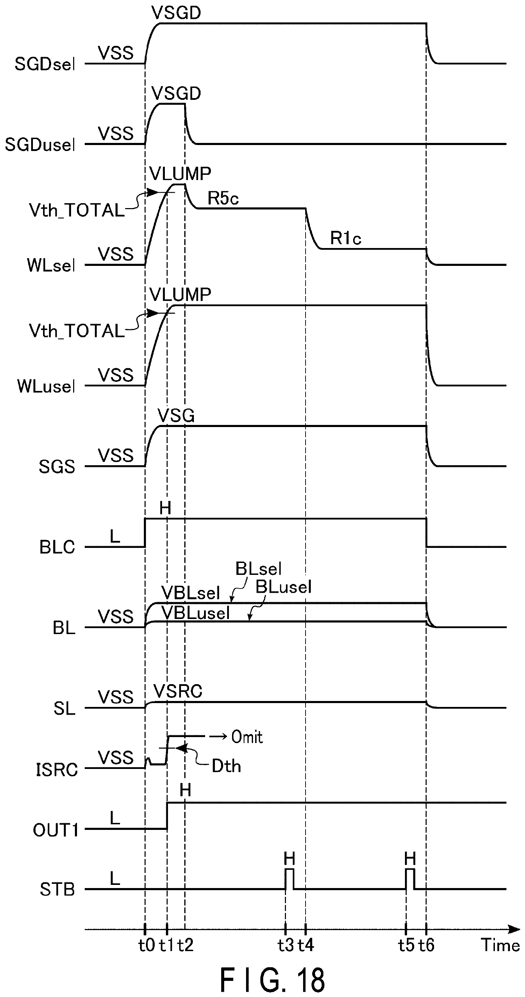

FIG. 18 is a diagram illustrating an example of an operation waveform of the correction read operation of the memory device 2 according to the first embodiment. In FIG. 18, changes in the voltages of the select gate line SGDsel, the select gate line SGDusel, the select word line WLsel, the unselected word line WLusel, the select gate line SGS, the control signal BLC, the bit line BL, the source line SL, the output signal OUT1, and the control signal STB, and changes in the current ISRC of the source line SL in the correction read operation for the lower page are illustrated. As illustrated in FIG. 18, in the normal read operation for the lower page data, the sequencer 24 sequentially executes the processing at times t0 to t6. At the start of the correction read operation, the voltage applied to each interconnect is the ground voltage VSS, and each control signal is at a low level.

At time t0, the sequencer 24 applies the voltage VSGD to each of the select gate lines SGDsel and SGDusel, applies the voltage VSGS to the select gate line SGS, applies the search voltage VLUMP to all the word lines WL including the select word line WLsel and the unselected word line WLusel, and applies the voltage VSRC to the source line SL. Furthermore, at time t0, the sequencer 24 sets the control signal BLC to the high level. Then, the sense amplifier unit SAU coupled to the selected bit line BLsel charges the selected bit line BLsel, and the voltage of the selected bit line BLsel rises to the voltage VBLsel. Similarly, the sense amplifier unit SAU coupled to the unselected bit line BLusel charges the unselected bit line BLusel, and the voltage of the unselected bit line BLusel rises to the voltage VBLusel. Note that the unselected bit line BLusel is not necessarily charged at time t0, and the voltage of the voltage VBLusel may be controlled to maintain the ground voltage VSS.

When the voltage of each word line WL starts to rise toward the search voltage VLUMP, first, a leakage current may flow through the plurality of NAND strings NS coupled to the selected bit line BLsel. Then, when the voltage of each word line WL further increases and reaches the bottom of the combined threshold voltage distribution of the block BLK, a current flows through the NAND string NS coupled to the selected bit line BLsel, and the current ISRC of the source line SL increases. In FIG. 18, a threshold at which a change in the current ISRC of the source line SL is detected by the detection circuit 30 is indicated by Dth. When the current ISRC exceeds the threshold Dth, the output signal OUT1 of the detection circuit 30 changes from a low level to a high level. Note that a timing at which a change in the current ISRC of the source line SL is detected by the detection circuit 30 is indicated by time t1. The voltage of each word line WL at time t1 corresponds to Vth_TOTAL. Then, the sequencer 24 determines the correction value of the read voltage used in the read operation for the lower page based on time t1.

Thereafter, at time t2, the sequencer 24 applies the ground voltage VSS to the select gate line SGDusel and applies the read voltage R5c to the selected word line WLsel. At this time, the sequencer 24 directly changes the search voltage VLUMP to the read voltage R5c without lowering the voltage to the ground voltage VSS. The read voltage R5c is the read voltage R5 to which the correction value determined based on the timing of time t1 is applied. The other operations at times t2 and t3 are similar to the operations at times t2 and t3 described with reference to FIG. 14, respectively. In other words, at time t3, the sequencer 24 asserts the control signal STB. As a result, a read result using the read voltage R5c is reflected on the bus LBUS, and the read result using the read voltage R5c is stored in a predetermined latch circuit.

Then, at time t4, the sequencer 24 applies a read voltage R1c to the selected word line WLsel. The read voltage R1c is the read voltage R1 to which the correction value determined based on the timing of time t1 is applied. The other operations at times t4 and t5 are similar to the operations at times t4 and t5 described with reference to FIG. 14, respectively. In other words, at time t5, the sequencer 24 asserts the control signal STB. As a result, a read result using the read voltage R5c is reflected on the bus LBUS, and the read result using the read voltage R1c is stored in a predetermined latch circuit.

At time t6, the sequencer 24 changes the voltage applied to each interconnect and the voltage of each control signal to the state at the start of the correction read operation. Then, the sequencer 24 determines the lower bit data based on the read result using the read voltage R1c and the read result using the read voltage R5c. Thereafter, the memory device 2 transmits the determined set of lower bit data as lower page data to the memory controller 1, and ends the correction line read operation for the lower page data. Note that the memory device 2 can execute the correction read operation in which another page is selected, similarly to the read operation for the lower page data, by changing the read voltage and the arithmetic processing for data determination.

### (4: Command Sequence of Correction Read Operation)

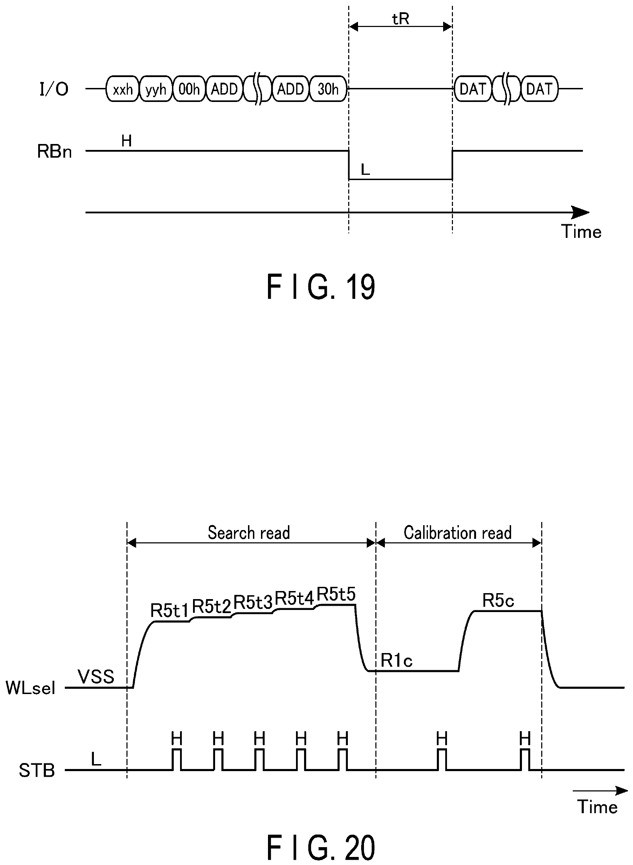

FIG. 19 is a diagram illustrating an example of a command sequence of the correction read operation of the memory device 2 according to the first embodiment. In FIG. 19, the input/output signal I/O and the ready/busy signal RBn in a case where the correction read operation is executed are illustrated. Before the start of the operation, the ready/busy signal RBn is "H" (high level: ready state). As illustrated in FIG. 19, when executing the correction read operation, first, the memory controller 1 transmits a command "xxh", a command "yyh", a command "00h", an address "ADD", and a command "30h" to the memory device 2 in this order.

The command "xxh" is used as an option and is a command that designates a correction read operation. The command "yyh" is a command instructing an operation corresponding to a specific page. The command "yyh" is changed according to the page to be read. The command "00h" is a command instructing a read operation. The address "ADD" may include information such as the block BLK to be read, the string unit SU, and the word line WL. The address "ADD" may be transmitted in multiple cycles. The command "30h" is a command instructing the memory device 2 to start the read operation based on the command and the address held in the register circuit 23.

When the command "30h" is held in the register circuit 23, the sequencer 24 changes the memory device 2 from the ready state (RBn= "H") to the busy state (RBn = "L" (low level: busy state)) and starts the correction read operation. In FIG. 19, a period during which the correction read operation is executed is indicated by tR. When the correction read operation is completed, the sequencer 24 changes the memory device 2 from the busy state to the ready state. When detecting the end of the read operation based on the change in the ready/busy signal RBn, the memory controller 1 sequentially outputs the read result (data DAT) to the memory device 2 by toggling the control signal REn, for example.

### <1-3> Advantageous Effects of First Embodiment

According to the first embodiment, it is possible to provide a memory device and a memory system MS that have high reliability and operate at a high speed. Hereinafter, details of the effects of the first embodiment will be described using a comparative example.

In a flash memory in which memory cells are three-dimensionally stacked, it is difficult to avoid deterioration of the characteristics of the memory cells due to reduction in the stacking interval and high stacking of the memory cells. In particular, in a case where 4-bit data or more is stored in one memory cell MC, error correction cannot be performed in a normal read operation, and the frequency of performing the on-chip tracking operation increases. The on-chip tracking operation is a read operation of performing a search read to search for a more suitable read voltage on the memory device 2 and then executing a calibration read using the suitable read voltage determined by the search.

FIG. 20 is a diagram illustrating an example of an operation waveform of an on-chip tracking operation in a comparative example. As illustrated in FIG. 20, in the on-chip tracking operation, a search read and a calibration read are sequentially executed. In the search read of the comparative example, for example, read processing using a plurality of voltages near the highest read voltage among a plurality of read voltages used in the page to be read is sequentially executed. In the comparative example, the search read targeted for only one level is executed in this manner, and the correction values of the read voltages of the other levels are estimated based on the result of the search read of one level. Thereafter, in the calibration read, the read processing is executed using the correction value determined based on the result of the search read. As described above, the on-chip tracking requires a lot of read processing. As the number of times of the read processing increases, the time for waiting for stability of the bit line BL and the time for bit counting increase. Therefore, a high-speed on-chip tracking technology is required.

On the other hand, the memory device 2 according to the first embodiment executes the correction read operation as the operation corresponding to the on-chip tracking operation. Specifically, the correction read operation includes a first read sequence (search read) and a second read sequence (calibration read). In the search read, the sequencer 24 increases the voltages of the plurality of word lines WL at the same speed, and determines the correction value of each of the plurality of read voltages based on the timing at which the amount of current via the plurality of NAND strings NS changes with the increase in the voltages of the plurality of word lines WL. In the calibration read, the sequencer 24 executes the read operation using the plurality of read voltages to which the correction values are applied.

As a result, the sequencer 24 can calculate the shift amount of the bottom of the combined threshold voltage distribution based on the voltage of the word line WL in the portion where the current of the source line SL has changed, and can determine a suitable correction value of the read voltage. As a result, the memory device 2 according to the first embodiment can execute the correction read operation capable of improving the read accuracy similarly to the on-chip tracking operation with a smaller number of reads than the comparative example.

### <1-4> Further Embodiments of First Embodiment

The memory system MS according to the first embodiment can be variously modified. Hereinafter, first to third further embodiments of the first embodiment will be described in order.

### (1: First Further Embodiment)

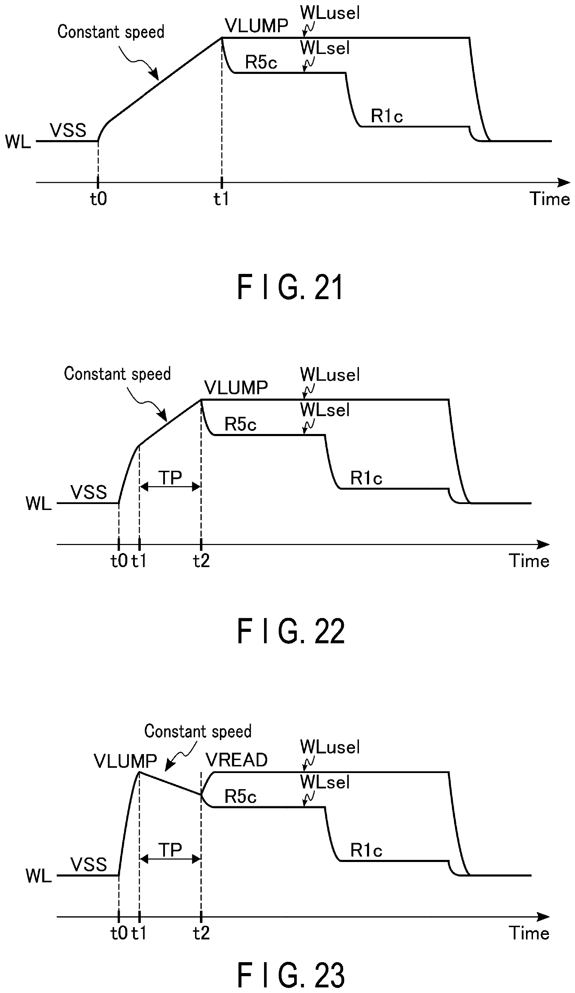

FIG. 21 is a diagram illustrating an example of an operation waveform of the correction read operation according to a first further embodiment of the first embodiment. In FIG. 21, a change in the voltage of the word line WL in the correction read operation of the first further embodiment of the first embodiment is illustrated. As illustrated in FIG. 21, in the first further embodiment of the first embodiment, the rising speed of the search voltage VLUMP to each word line WL is slower than that in the first embodiment.

Specifically, at time t0, the sequencer 24 starts applying a voltage to each word line WL toward the search voltage VLUMP. Then, the sequencer 24 controls the rising speed of the search voltage VLUMP to be slower than that in the correction read operation of the first embodiment and to be a constant speed from the middle. In this example, the voltage of each word line WL reaches the search voltage VLUMP at time t1. In addition, between the times t0 and t1, the detection circuit 30 detects the timing at which the current flows through the source line SL. Then, after time t1, the sequencer 24 executes the calibration read using the read voltage to which the correction value based on the timing detected by the detection circuit 30 is applied, similarly to the first embodiment.

The rate of increase in the voltage of the word line WL can vary depending on the distance from the driver circuit 26. In other words, the rate of increase in the voltage of the word line WL may be delayed according to the distance (perspective difference) from the driver circuit 26. Such a delay may cause the spread of the threshold voltage distribution. On the other hand, in the first further embodiment of the first embodiment, the rising speed of the voltage of each word line WL is controlled to be slower than that in the first embodiment. As a result, the perspective difference of the voltage of the word line WL is suppressed, and the spread of the threshold voltage distribution caused by the perspective difference can be suppressed. As a result, in the memory system MS according to the first further embodiment of the first embodiment, the detection circuit 30 can detect the bottom of the combined threshold voltage distribution with higher accuracy than in the first embodiment.

### (2: Second Further Embodiment)

FIG. 22 is a diagram illustrating an example of an operation waveform of the correction read operation according to a second further embodiment of the first embodiment. In FIG. 22, a change in the voltage of the word line WL in the correction read operation of the second further embodiment of the first embodiment is illustrated. As illustrated in FIG. 22, in the second further embodiment of the first embodiment, the rising speed of the search voltage VLUMP to each word line WL is the same until reaching a detection period TP as that in the first embodiment, and is slower in the detection period TP than that in the first embodiment.

Specifically, at time t0, the sequencer 24 starts applying a voltage to each word line WL toward the search voltage VLUMP. Then, the sequencer 24 controls the rising speed of the search voltage VLUMP similarly to the correction read operation of the first embodiment until time t1. Then, the sequencer 24 controls the rising speed of the search voltage VLUMP, in the detection period TP between time t1 and time t2, to be slower than that in the correction read operation of the first embodiment and to be a constant speed. In this example, the voltage of each word line WL reaches the search voltage VLUMP at time t2. In the detection period TP, the detection circuit 30 detects the timing at which the current flows through the source line SL. Then, after time t2, the sequencer 24 executes the calibration read using the read voltage to which the correction value based on the timing detected by the detection circuit 30 is applied, similarly to the first embodiment.

In the second further embodiment of the first embodiment, the detection period TP is set in advance according to a range in which the combined threshold voltage distribution can be formed. Then, since the voltage of each word line WL is rapidly raised to the target (detection period TP), the processing time of the correction read operation of the second further embodiment of the first embodiment can be shortened as compared with the first further embodiment of the first embodiment. Therefore, in the memory system MS according to the second further embodiment of the first embodiment, the detection circuit 30 can detect the bottom of the combined threshold voltage distribution with higher accuracy than in the first embodiment, and the correction read operation can be executed at higher speed than in the first further embodiment of the first embodiment.

### (3: Third Further Embodiment)

FIG. 23 is a diagram illustrating an example of an operation waveform of the correction read operation according to a third further embodiment of the first embodiment. In FIG. 23, a change in the voltage of the word line WL in the correction read operation of the third further embodiment of the first embodiment is illustrated. As illustrated in FIG. 23, in the third further embodiment of the first embodiment, the rising speed of the search voltage VLUMP to each word line WL is faster than that of the first embodiment until reaching the detection period TP. Then, the sequencer 24 controls the voltage of each word line WL to fall at a constant speed in the detection period TP.

Specifically, at time t0, the sequencer 24 starts applying a voltage to each word line WL toward the search voltage VLUMP. In addition, the sequencer 24 controls the rising speed of the search voltage VLUMP to be faster than that in the correction read operation of the first embodiment. In this example, the voltage of each word line WL reaches the search voltage VLUMP at time t1. Then, in the detection period TP starting from time t1, the sequencer 24 decreases the voltage of each word line WL from the search voltage VLUMP at a constant speed. In the present example, at time t2, the detection circuit 30 detects the timing at which the current of the source line SL is cut off. In addition, based on the detection of the timing at which the current of the source line SL is cut off, the sequencer 24 executes the calibration read using the read voltage to which the correction value based on the timing detected by the detection circuit 30 is applied, similarly to the first embodiment. In the correction read operation of the third further embodiment of the first embodiment, the voltage of the selected word line WLsel transitions from the voltage at which the bottom of the combined threshold voltage distribution is detected to the read voltage (for example, R5c) to which the correction value is applied.

In the third further embodiment of the first embodiment, the detection circuit 30 detects the bottom of the combined threshold voltage distribution based on the fact that the current of the source line SL falls below the threshold value Dth of the current of the source line SL described with reference to FIG. 18 in the first embodiment. In the third further embodiment of the first embodiment, the length of the detection period TP changes based on the timing detected by the detection circuit 30. Then, since the voltage of each word line WL is rapidly raised to the target (detection period TP), the processing time of the correction read operation of the third further embodiment of the first embodiment can be shortened as compared with the first further embodiment of the first embodiment. Therefore, in the memory system MS according to the third further embodiment of the first embodiment, the detection circuit 30 can detect the bottom of the combined threshold voltage distribution with higher accuracy than in the first embodiment, and the correction read operation can be executed at higher speed than in the first further embodiment of the first embodiment.

### <2> Second Embodiment

A memory system MS according to a second embodiment executes the correction read operation described in the first embodiment, mainly selecting the plurality of bit lines BL arranged on the side of the word line WL coupled to the driver circuit 26. Hereinafter, details of the memory system MS according to the second embodiment will be described mainly on differences from the first embodiment.

### <2-1> Configuration

The configuration of the memory system MS according to the second embodiment is similar to that of the first embodiment.

### <2-2> Operation

Hereinafter, an operation of the memory system MS according to the second embodiment will be described.

### <2-2-1> Arrangement of Bit Lines BL Selected in Correction Read Operation

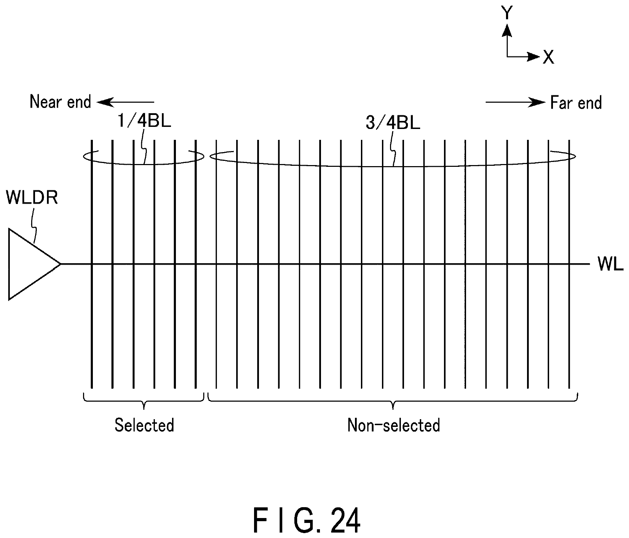

FIG. 24 is a diagram illustrating an example of arrangement of bit lines BL selected at the time of detecting a combined threshold voltage distribution in a correction read operation of a memory device 2 according to the second embodiment. In FIG. 24, one word line WL coupled to a word line driver WLDR and a plurality of bit lines BL arranged in the X direction are illustrated. Note that the word line driver WLDR is included in the driver circuit 26. The word line driver WLDR and the word line WL are coupled via a transistor TR. The near end of the word line WL corresponds to a portion close to a connection portion with the transistor TR. The far end of the word line WL corresponds to a portion far from the connection point with the transistor TR.

As illustrated in FIG. 24, in the correction read operation of the memory system MS according to the second embodiment, the plurality of bit lines BL arranged on the near end side of the word line WL are selected, and the plurality of bit lines BL arranged on the far end side of the word line WL are unselected. In other words, the plurality of NAND strings NS includes a plurality of first strings coupled to some bit lines BL and a plurality of second strings coupled to other bit lines BL. The interval between the driver circuit 26 and the connection portion between the plurality of word lines WL is wider in the plurality of second strings than in the plurality of first strings. Specifically, for example, 1/4 of the bit lines BL (1/4BL) on the near end side among the plurality of bit lines BL are selected, and 3/4 of the bit lines BL (3/4BL) on the far end side among the plurality of bit lines BL are unselected.

At the time of detection of the combined threshold voltage distribution in the correction read operation of the second embodiment, at least a smaller number of bit lines BL are selected than the number of bit lines BL selected as targets to be read. Further, it is more preferable that the arrangement of the plurality of bit lines BL selected at the time of detecting the combined threshold voltage distribution is unevenly distributed on the near end side of the word line WL. In the second embodiment, it is more preferable to select 1/M (M is an integer of 2 or larger) bit lines BL on the near end side of the word line WL among the plurality of bit lines BL at the time of detection of the combined threshold voltage distribution.

### <2-2-2> Operation Waveform of Correction Read Operation

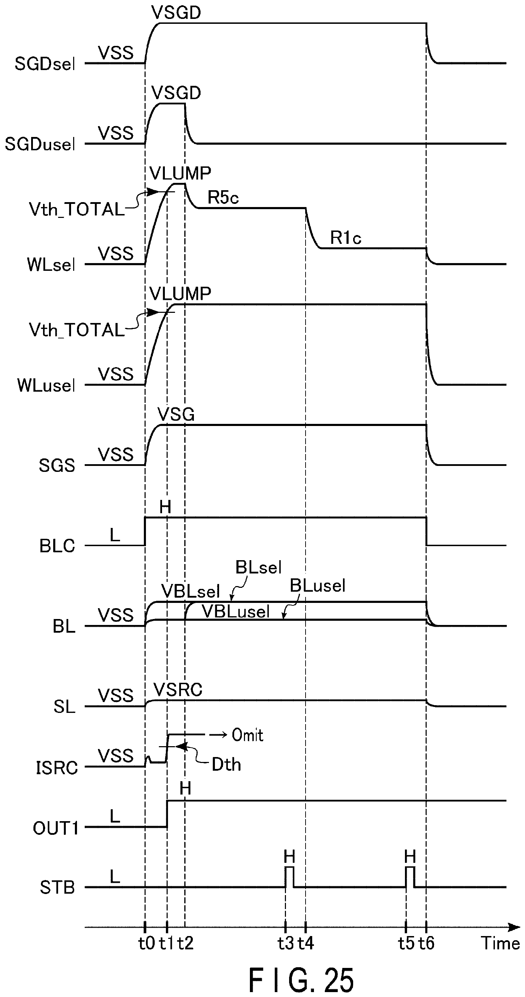

FIG. 25 is a diagram illustrating an example of an operation waveform of the correction read operation of the memory device 2 according to the second embodiment. In FIG. 25, changes in the voltages of the select gate line SGDsel, the select gate line SGDusel, the selected word line WLsel, the unselected word line WLusel, the select gate line SGS, the control signal BLC, the bit line BL, the source line SL, the output signal OUT1, and the control signal STB, and changes in the current ISRC of the source line SL in the correction read operation for the lower page are illustrated.

As illustrated in FIG. 25, the correction read operation in the second embodiment is different from the correction read operation described with reference to FIG. 18 in the first embodiment in the operation of the bit line BL. Specifically, between times t0 and t2, the voltage VBLsel is applied to the selected bit line BLsel, and the voltage VBLusel is applied to the unselected bit line BLusel. At this time, the bit line BL selected is a plurality of bit lines BL arranged on the near end side of the word line WL as illustrated in FIG. 24. Then, similarly to the first embodiment, the detection circuit 30 detects the timing at which the current ISRC flows through the source line SL at time t1. Then, at time t2, the sequencer 24 starts a calibration read. At this time, the sequencer 24 applies the voltage VBLsel to all the bit lines BL coupled to the memory cell transistors MT to be read. That is, at time t2, the sequencer 24 changes the bit line BL that is unselected at the time of detection of the combined threshold voltage distribution to the selected bit line BLsel, and executes the correction read operation. Other operations of the memory system MS according to the second embodiment is similar to those of the first embodiment.

### <2-3> Advantageous Effects of Second Embodiment

As described above, in the memory device 2 according to the second embodiment, in a case where each of the plurality of bit lines BL is a target to be read in the search read, the sequencer 24 is configured to charge only some bit lines BL of the plurality of bit lines BL when a voltage is applied to the plurality of word lines WL, and charge the plurality of bit lines BL when a read voltage is applied to the plurality of word lines WL in the calibration read.

For example, in the memory device 2 according to the second embodiment, only the bit line BL corresponding to, for example, 1/4 (4KB) on the near end side of the word line WL is selected, and the bottom of the combined threshold voltage distribution is detected. As a result, the spread of the combined threshold voltage distribution due to the perspective difference of the voltage of the word line WL can be suppressed. As a result, in the memory device 2 according to the second embodiment, even if the rising speed of the search voltage VLUMP is set to be higher than that in the first embodiment, it is possible to suppress the spread of the combined threshold voltage distribution. Therefore, the second embodiment can provide the memory device 2 and the memory system MS that have high reliability similarly to the first embodiment and can operate at a higher speed than the first embodiment.

### <3> Third Embodiment

The memory system MS according to a third embodiment changes a part of the operation of the correction read operation described in the first embodiment according to the state of the block BLK. Hereinafter, details of the memory system MS according to the third embodiment will be described mainly on differences from the first and second embodiments.

### <3-1> Configuration

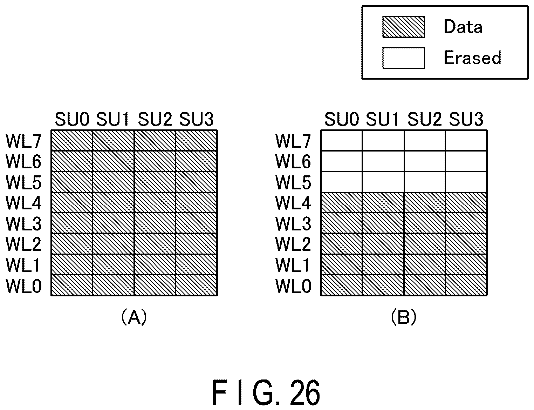

FIG. 26 is a diagram illustrating an example of a state of a block BLK included in a memory cell array 20 included in a memory device 2 according to the third embodiment. In FIG. 26, a case where the number of word lines WL provided in the block BLK is eight is illustrated. In (A) of FIG. 26, a state in which the write operation for all the word lines WL in the block BLK is executed and data is written in all the cell units CU in the block BLK is illustrated. In (B) of FIG. 26, a state in which the write operation for some of the word lines WL in the block BLK is executed and data is written in some of the cell units CU in the block BLK is illustrated.

Hereinafter, the block BLK in which data is written in all the cell units CU therein is referred to as a "closed block". The block BLK in which data is written in some of the internal cell units CU is referred to as an "open block". The memory controller 1 according to the third embodiment can manage which page (word line WL) is unwritten (that is, in the open state,). Other configurations of the memory system MS according to the third embodiment is similar to those of the first embodiment.

### <3-2> Operation

Hereinafter, an operation of the memory system MS according to the third embodiment will be described.

### <3-2-1> Processing Procedure of Correction Read Operation

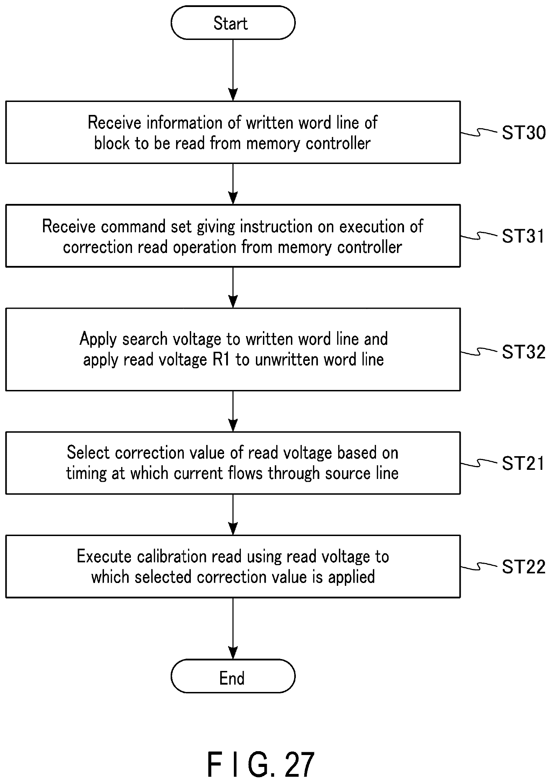

FIG. 27 is a flowchart illustrating an example of a processing procedure of a correction read operation of the memory system MS according to the third embodiment. For example, in a case where the error correction in the normal read operation fails, the memory system MS starts a series of processing in FIG. 27 (start).

First, the memory device 2 receives information of the written word line WL(that is, the cell unit CU) of the block BLK to be read from the memory controller 1 (step ST30). For example, the memory controller 1 transmits the information of the written word line WL to the memory device 2 through Set Feature or the like. The information of the written word line WL is stored in a predetermined area of the memory device 2 (for example, register circuit 23) .

Next, the memory device 2 receives a command set instructing execution of the correction read operation from the memory controller 1 (step ST31). The command set used in step ST31 is, for example, similar to the command set described in the first embodiment with reference to FIG. 19. Then, the memory device 2 starts the correction read operation based on the reception of the command set.

Next, in the selected block BLKsel, the memory device 2 applies the search voltage VLUMP to the written word line WL and applies, for example, the read voltage R1 to the unwritten word line WL (step ST32). The voltage applied to the unwritten word line WL in step ST32 may be other voltages as long as the memory cell transistor MT in the erase state can be turned on.

Next, as in the first embodiment, the memory device 2 selects a correction value of the read voltage based on the timing at which the current flows through the source line SL (step ST21) .

Next, as in the first embodiment, the memory device 2 executes a calibration read using the read voltage to which the selected correction value is applied (step ST22). When the calibration read is completed, the memory device 2 outputs the read result to the memory controller 1 and ends the series of processing of FIG. 27 (end).

### <3-2-2> Operation Waveform of Correction Read Operation

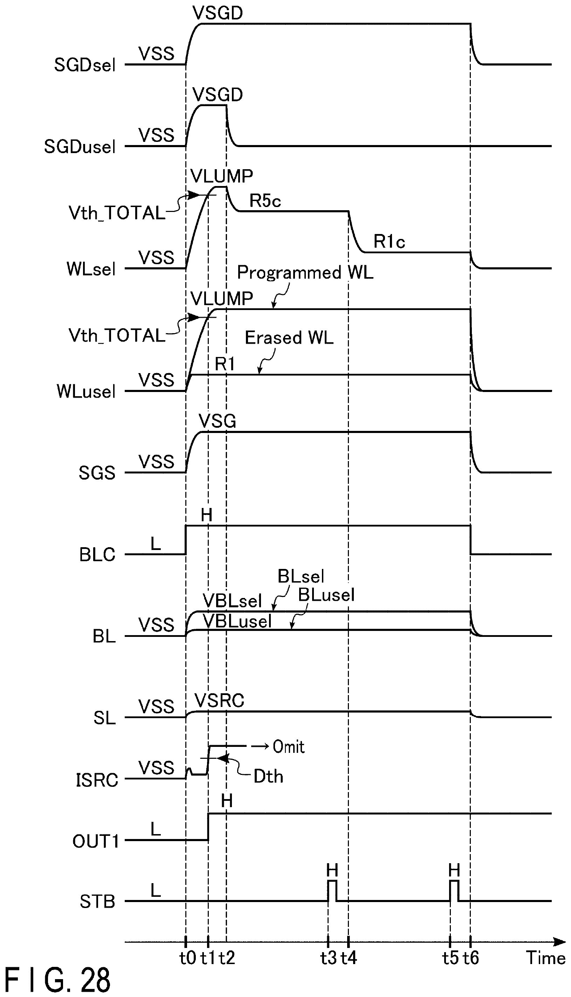

FIG. 28 is a diagram illustrating an example of an operation waveform of the correction read operation of the memory device according to the third embodiment. In FIG. 28, changes in the voltages of the select gate line SGDsel, the select gate line SGDusel, the selected word line WLsel, the unselected word line WLusel, the select gate line SGS, the control signal BLC, the bit line BL, the source line SL, the output signal OUT1, and the control signal STB, and changes in the current ISRC of the source line SL in the correction read operation for the lower page are illustrated.

As illustrated in FIG. 28, the correction read operation in the third embodiment is different from the correction read operation described with reference to FIG. 18 in the first embodiment in the operation of the unselected word line WLusel. Specifically, the correction read operation in a case where the block BLK to be read is a closed block is similar to that of the first embodiment. On the other hand, the correction read operation in a case where the block BLK to be read is an open block is different in that a predetermined read voltage is applied to the unwritten unselected word line WLusel.

More specifically, in the correction read operation, the sequencer 24 applies, for example, the search voltage VLUMP to the written word line WL (Programmed WL), and applies the read voltage R1 to the unwritten unselected word line WLusel (Erased WL). Note that the read voltage applied to the unwritten unselected word line WLusel is not limited to the read voltage R1, and may be any voltage as long as the memory cell transistor MT in the state corresponding to the erase state (for example, state SO) can be turned on.

### <3-3> Advantageous Effects of Third Embodiment

In a case where the search voltage VLUMP is applied to the unselected word line WL of the open block at the time of search read, there is a possibility that the combined threshold voltage distribution cannot be accurately detected. Therefore, in the memory system MS according to the third embodiment, the memory controller 1 transmits information on the unwritten word line WL to the memory device 2. Then, the memory device 2 applies the read voltage R1 to the word line WL in the open state at the time of search read of the correction read operation. As described above, by applying the read voltage R1 lower than the read path voltage to the word line WL in the open state, the possibility of erroneous detection of the combined threshold voltage distribution can be suppressed. Therefore, the memory system MS according to the third embodiment has higher reliability than the first embodiment and can operate at a high speed as in the first embodiment.

### <4> Fourth Embodiment

The memory system MS according to a fourth embodiment logically divides and manages the block BLK. In the fourth embodiment, the correction read operation described in the third embodiment is applied according to the state of the logically divided block BLK. Hereinafter, details of the memory system MS according to the fourth embodiment will be described mainly on differences from the first and second embodiments.

### <4-1> Configuration

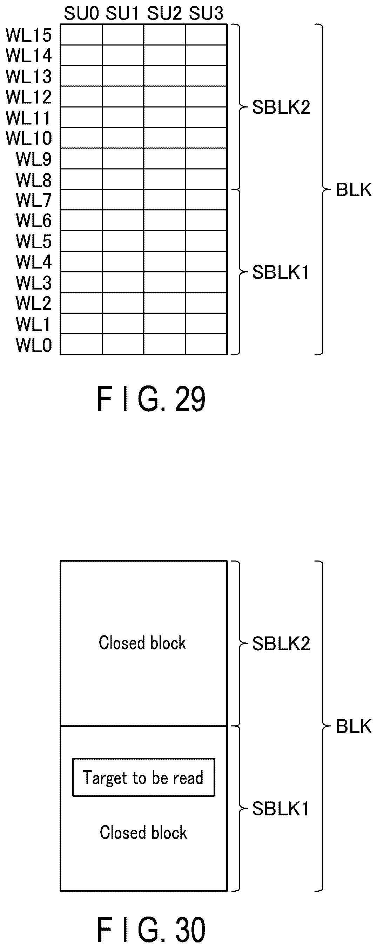

FIG. 29 is a diagram illustrating an example of a configuration of a block included in a memory cell array included in a memory device 2 according to the fourth embodiment. In FIG. 29, a case where the number of word lines WL provided in the block BLK is 16 is illustrated. As illustrated in FIG. 29, in a memory cell array 20 included in the memory device 2 according to the fourth embodiment, the block BLK is divided into a plurality of sub-blocks SBLK and managed. Specifically, each block BLK includes sub-blocks SBLK1 and SBLK2. For example, the sub-block SBLK1 is associated with the word lines WL0 to WL7, and the sub-block SBLK2 is associated with the word lines WL8 to WL15.

The number of sub-blocks SBLK allocated to each block BLK may be three or more. The number of word lines WL associated with each sub-block SBLK may be one or more. The memory controller 1 may be configured to be able to change whether or not to use the sub-block SBLK according to the operation mode. For example, when used in the sub-block mode, the memory controller 1 manages each block BLK in the memory device 2 using a plurality of sub-blocks SBLK. Other configurations of the memory system MS according to the fourth embodiment is similar to those of the first embodiment.

### <4-2> Operation

In the correction read operation of the memory system MS according to the fourth embodiment, the voltage applied to the unselected word line WLusel is selected similarly to the third embodiment depending on whether the sub-block SBLK is a closed block or an open block. Hereinafter, first to fifth examples of the state of the block BLK that is the target of the correction read operation of the memory system MS according to the fourth embodiment will be described.

FIG. 30 is a diagram illustrating the first example of a state of a block BLK that is a target of the correction read operation of the memory system MS according to the fourth embodiment. As illustrated in FIG. 30, in the block BLK of the first example, each of the sub-blocks SBLK1 and SBLK2 is a closed block. Then, the sub-block SBLK1 includes a page to be read. In this case, in the correction read operation, the sequencer 24 applies the search voltage VLUMP to the unselected word line WLusel of each of the sub-blocks SBLK1 and SBLK2. Other operations of the correction read operation in the first example are similar to those of the correction read operation of the third embodiment.

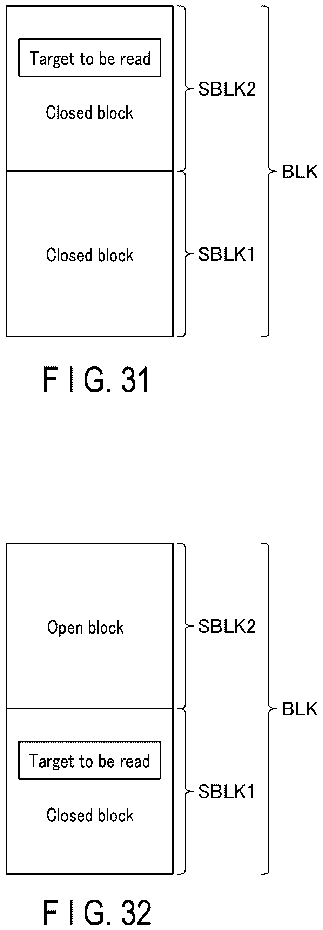

FIG. 31 is a diagram illustrating the second example of a state of a block that is a target of the correction read operation of the memory system MS according to the fourth embodiment. As illustrated in FIG. 31, in the block BLK of the second example, each of the sub-blocks SBLK1 and SBLK2 is a closed block. Then, the sub-block SBLK2 includes a page to be read. In this case, in the correction read operation, the sequencer 24 applies the search voltage VLUMP to the unselected word line WLusel of each of the sub-blocks SBLK1 and SBLK2. Other operations of the correction read operation in the second example are similar to those of the correction read operation described in the third embodiment.

FIG. 32 is a diagram illustrating the third example of a state of a block that is a target of the correction read operation of the memory system MS according to the fourth embodiment. As illustrated in FIG. 32, in the block BLK of the third example, each of the sub-blocks SBLK1 and SBLK2 is a closed block and an open block. Then, the sub-block SBLK1 includes a page to be read. In this case, in the correction read operation, the sequencer 24 applies the search voltage VLUMP to the unselected word line WLusel of the sub-block SBLK1. In addition, the sequencer 24 applies the search voltage VLUMP to the written unselected word line WLusel of the sub-block SBLK2, and applies, for example, the read voltage R1 to the unwritten unselected word line WLusel of the sub-block SBLK2. Other operations of the correction read operation in the third example are similar to those of the correction read operation of the third embodiment.

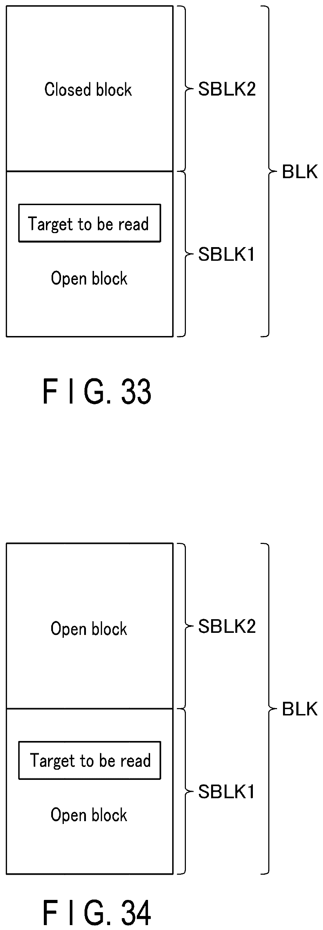

FIG. 33 is a diagram illustrating the fourth example of a state of a block that is a target of the correction read operation of the memory system MS according to the fourth embodiment. As illustrated in FIG. 33, in the block BLK of the fourth example, the sub-blocks SBLK1 and SBLK2 are an open block and a closed block, respectively. Then, the sub-block SBLK1 includes a page to be read. In this case, in the correction read operation, the sequencer 24 applies the search voltage VLUMP to the written unselected word line WLusel of the sub-block SBLK1, and applies, for example, the read voltage R1 to the unwritten unselected word line WLusel of the sub-block SBLK1. In addition, the sequencer 24 applies the search voltage VLUMP to the unselected word line WLusel of the sub-block SBLK2. Other operations of the correction read operation in the fourth example are similar to those of the correction read operation of the third embodiment.

FIG. 34 is a diagram illustrating the fifth example of a state of a block that is a target of the correction read operation of the memory system MS according to the fourth embodiment. As illustrated in FIG. 34, in the block BLK of the fifth example, each of the sub-blocks SBLK1 and SBLK2 is an open block. Then, the sub-block SBLK1 includes a page to be read. In this case, in the correction read operation, the sequencer 24 applies the search voltage VLUMP to the written unselected word line WLusel of the sub-blocks SBLK1 and SBLK2, and applies, for example, the read voltage R1 to the unwritten unselected word line WLusel of the sub-blocks SBLK1 and SBLK2. Other operations of the correction read operation in the fifth example are similar to those of the correction read operation of the third embodiment.

Other operations of the memory system MS according to the fourth embodiment is similar to those of the first embodiment.

### <4-3> Advantageous Effects of Fourth Embodiment

As described above, the memory system MS according to the fourth embodiment can use the sub-block mode and execute the same correction read operation as in the third embodiment. As a result, in the memory system MS according to the fourth embodiment, if the sub-block mode is used, the applied voltage of the unselected word line WLusel can be changed according to the write/erase state of the sub-block SBLK. As a result, the memory system MS according to the fourth embodiment has high reliability and can operate at a high speed as in the third embodiment.

If the sub-block mode is used, the shift amount of the combined threshold voltage distribution may be different between the sub-blocks SBLK.

Therefore, in the correction read operation of the memory system MS according to the fourth embodiment, the sequencer 24 sets the rising speed of the search voltage VLUMP or the read path voltage VREAD in the sub-block SBLK to be read to a constant speed as in the first to second further embodiments of the first embodiment. Then, the sequencer 24 may set the rising speed of the search voltage VLUMP or the read path voltage VREAD in the unselected sub-block SBLK to be faster than that of the sub-block SBLK to be read.

As a result, the memory system MS can suppress the influence of the shift amount of the combined threshold voltage distribution of the memory cell transistors MT in the unselected sub-block SBLK on the shift amount of the combined threshold voltage distribution in the sub-block SBLK to be read. As a result, the memory system MS according to the fifth embodiment can improve the detection accuracy of the bottom of the combined threshold voltage distribution at the time of using the sub-block mode.

### <5> Fifth Embodiment

The memory system MS according to the fifth embodiment executes a simple tracking operation for the read voltage associated with the low state in the correction read operation described in the first embodiment, and improves the read accuracy for the low state. Hereinafter, details of the memory system MS according to the fifth embodiment will be described mainly on differences from the first and fourth embodiments.

### <5-1> Configuration

The configuration of the memory system MS according to the fifth embodiment is similar to that of the first embodiment.

### <5-2> Operation

Hereinafter, an operation of the memory system MS according to the fifth embodiment will be described. In the correction read operation of the memory system MS according to the fifth embodiment, a method of calibration read is different from that of the first embodiment. In addition, in the calibration read of the memory system MS according to the fifth embodiment, the control method of the sense amplifier module 29 is different depending on whether or not the correction read operation is executed when the write operation is suspended.

### <5-2-1> First Example of Correction Read Operation

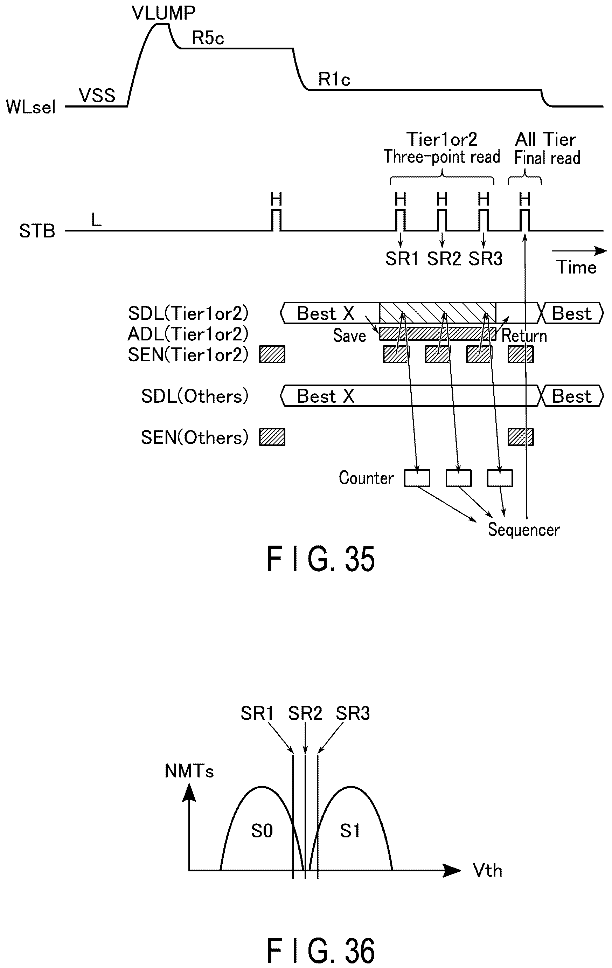

FIG. 35 is a diagram illustrating a first example of the operation waveform of the correction read operation and the method of using the sense amplifier module 29 of the memory system MS according to the fifth embodiment. FIG. 35 illustrates a case where the correction read operation is executed when the write operation is not suspended. As illustrated in FIG. 35, the sequencer 24 detects the combined threshold voltage distribution similarly to the first embodiment. Then, in the correction read operation, the sequencer 24 executes the three-point read at the lowest read voltage used in the page to be read (for example, R1c). The three-point read is a read operation of searching for valley positions of two adjacent states, and a suitable read voltage between the two adjacent states can be determined.

Specifically, first, as in the first embodiment, the search voltage VLUMP is applied to the selected word line WLsel, and the detection circuit 30 detects the combined threshold voltage distribution. Then, the sequencer 24 executes calibration read based on a detection result of the combined threshold voltage distribution. In this example, since the lower page is a target to be read, first, the read processing using the read voltage R5c is executed. When the control signal STB is asserted while the read voltage R5c is applied to the selected word line WLsel, the read result (voltage of the sense node SEN) is transferred to the bus LBUS of each sense amplifier unit SAU. Then, in each sense amplifier unit SAU, the read result transferred to the bus LBUS is transferred to the latch circuit SDL (Best X). Then, three-point read of the read voltage R1c is executed.

The three-point read in the first example of the fifth embodiment is executed using, for example, the sense amplifier unit SAU of Tier 1 or 2 in the sense amplifier module 29, and other sense amplifier units SAU (Others) are not used. Specifically, first, the sequencer 24 saves (transfers) the data (Best X) stored in the latch circuit SDL of the sense amplifier unit SAU of Tier 1 or 2 to a latch circuit (for example, the latch circuit ADL) sharing the bus LBUS. Then, the sequencer 24 charges the selected bit line BLsel and asserts the control signal STB three times at different timings.

In this example, the three read results are illustrated as read results SR1 to SR3, respectively. Each of the read results SR1 to SR3 is transferred to a counter in the memory device 2 via the latch circuit SDL, and is counted by a counter provided outside the sense amplifier module 29. At this time, the counter counts the number of "0" data or "1" data included in the read results SR1 to SR3. When the three-point read is completed, the data (Best X) saved in the latch circuit ADL of the sense amplifier unit SAU of the tier 1 or 2 is returned to the latch circuit SDL.

Then, the sequencer 24 determines a suitable read voltage or a suitable read timing based on the count result of each of the read results SR1 to SR3. Then, the sequencer 24 recharges the selected bit line BLsel and executes final read using a suitable read voltage or read timing (sense time) using all the sense amplifier units SAU to be read (All Tier final read). As a result, each sense amplifier unit SAU determines read data of the lower page (Best) based on the read result read to the bus LBUS and the data of the latch circuit SDL.

FIG. 36 is a diagram illustrating an example of a measurement target by three-point read of the memory system MS according to the fifth embodiment. In FIG. 36, a relationship between the three-point read for the read voltage R1c illustrated in FIG. 35 and the threshold voltage distribution of the memory cell transistor MT are illustrated. As illustrated in FIG. 36, the level of the threshold voltage associated with the read results SR1 to SR3 changes according to the assertion timing of the control signal STB. Specifically, detection according to the level of the threshold voltage can be performed by modulation of the sense time or the sense voltage in each assertion. As a result, the sequencer 24 can detect valley portions of two adjacent states S0 and S1 based on the read results SR1 to SR3, and can determine a suitable read voltage or read timing. Such three-point read may be applied to two other adjacent states.

### <5-2-2> Second Example of Correction Read Operation

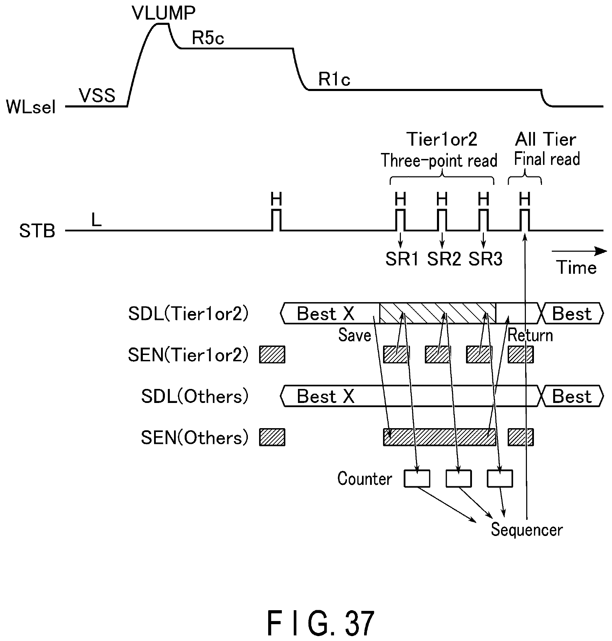

FIG. 37 is a diagram illustrating a second example of the operation waveform of the correction read operation and the method of using the sense amplifier module 29 of the memory system MS according to the fifth embodiment. In FIG. 37, a case where the correction read operation is executed when the write operation is suspended is illustrated. In this example, the lower page is a target to be read. As illustrated in FIG. 37, the sequencer 24 detects the combined threshold voltage distribution similarly to the first embodiment. Then, in the correction read operation, the sequencer 24 executes the three-point read at the lowest read voltage R1c used in the page to be read.

Detection of the combined threshold voltage distribution by the detection circuit 30 is similar to that in the first example in the fifth embodiment. In the calibration read, the sequencer 24 first executes the read processing using the read voltage R5c. When the control signal STB is asserted while the read voltage R5c is applied to the selected word line WLsel, the read result (voltage of the sense node SEN) is transferred to the bus LBUS of each sense amplifier unit SAU. Then, in each sense amplifier unit SAU, the read result transferred to the bus LBUS is transferred to the latch circuit SDL (Best X). Subsequently, three-point read of the read voltage R1c is executed.

The three-point read in the second example of the fifth embodiment is executed using, for example, the sense amplifier unit SAU of Tier 1 or 2 in the sense amplifier module 29, and other sense amplifier units SAU (Others) are not used. Specifically, first, the sequencer 24 saves (transfers) the data (Best X) stored in the latch circuit SDL of the sense amplifier unit SAU of Tier 1 or 2 to the sense node SEN of another sense amplifier unit SAU sharing the bus DBUS. Then, the sequencer 24 charges the selected bit line BLsel and asserts the control signal STB three times at different timings. When the three-point read is completed, the data (Best X) saved in the sense node SEN of another sense amplifier unit SAU is returned to the latch circuit SDL. Other operations in the second example of the fifth embodiment are similar to those in the first example of the fifth embodiment.

Other operations of the memory system MS according to the fifth embodiment is similar to those of the first embodiment. In the correction read operation of the fifth embodiment, the case where the three-point read is executed in the read processing on the state side where the threshold voltage is low has been exemplified, but the present invention is not limited thereto. The three-point read in the fifth embodiment may be a read operation of acquiring a plurality of read results by changing the sense time without changing the voltage of the selected word line WLsel and determining a suitable read voltage based on the acquired plurality of read results.

### <5-3> Advantageous Effects of Fifth Embodiment

In the correction read operation described in the first to fourth embodiments, the shift amount of the threshold voltage distribution due to the data retention at another level is estimated based on the shift information of the threshold voltage distribution on the state side where the threshold voltage is high. On the other hand, regarding the threshold voltage distribution on the state side where the threshold voltage is low, the influence of the shift component of the threshold voltage distribution due to the read disturb is also large.

Therefore, the memory device 2 according to the fifth embodiment executes three-point read with respect to the read processing on the state side having a low threshold voltage. As a result, the memory device 2 according to the fifth embodiment can improve the read accuracy on the state side where the threshold voltage is low. Therefore, the memory device 2 according to the fifth embodiment can achieve both high speed and high accuracy.

In addition, there is a case where only the sense node SEN and the latch circuit SDL can be used for data in the sense amplifier unit SAU at the time of suspending a write operation or the like. In this case, the normal read operation at the time of suspending is executed by rewriting the data of the latch circuit SDL by a No Lockout (NLK) operation. In the correction read operation at the time of suspending, the NLK operation in which the latch circuit SDL is not used for charge control of the bit line BL is executed, and then the sense operation limited to tier 1 or 2 is executed at the time of three-point read. Then, at the time of three-point read, the read result stored in the latch circuit SDL of the sense amplifier unit SAU of tier 1 or 2 is saved to the sense node SEN of the sense amplifier unit SAU sharing the bus DBUS. As described above, the memory system MS according to the fifth embodiment can avoid shortage of the latch circuit in the sense amplifier unit SAU by using the sense node SEN of the sense amplifier unit SAU sharing the bus DBUS.

In the fifth embodiment, the number of tiers of the sense amplifier unit SAU used at the time of three-point read may be smaller than the total number of tiers. The number of tiers of the sense amplifier unit SAU used at the time of three-point read is more preferably close to one.

### <5-4> Further embodiment of Fifth Embodiment

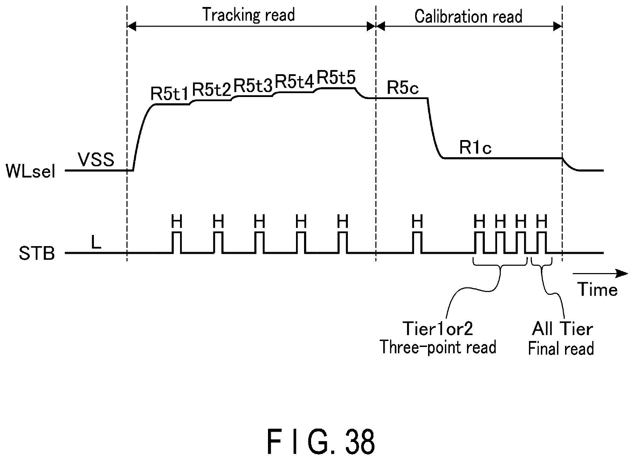

FIG. 38 is a diagram illustrating an example of an operation waveform of the correction read operation according to a further embodiment of the fifth embodiment. As illustrated in FIG. 38, in the further embodiment of the fifth embodiment, the search read in the comparative example described with reference to FIG. 20 and the calibration read described in the fifth embodiment are combined. As such, the calibration read described in the fifth embodiment may be combined with various kinds of search read. As a result, the memory system MS according to the further embodiment of the fifth embodiment can set the read voltage set on the low state side to a more preferable voltage, and can improve the read accuracy.

### <6> Sixth Embodiment

The memory system MS according to the sixth embodiment detects the combined threshold voltage of the plurality of memory cell transistors MT coupled in series in the NAND string NS based on the voltage change of the predetermined node on the bit line BL side in the correction read operation described in the first embodiment. Hereinafter, details of the memory system MS according to the sixth embodiment will be described mainly on differences from the first and fifth embodiments.

### <6-1> Configuration

First, a configuration of the memory system MS according to the sixth embodiment will be described.

### <6-1-1> Configuration of Memory Device 2A

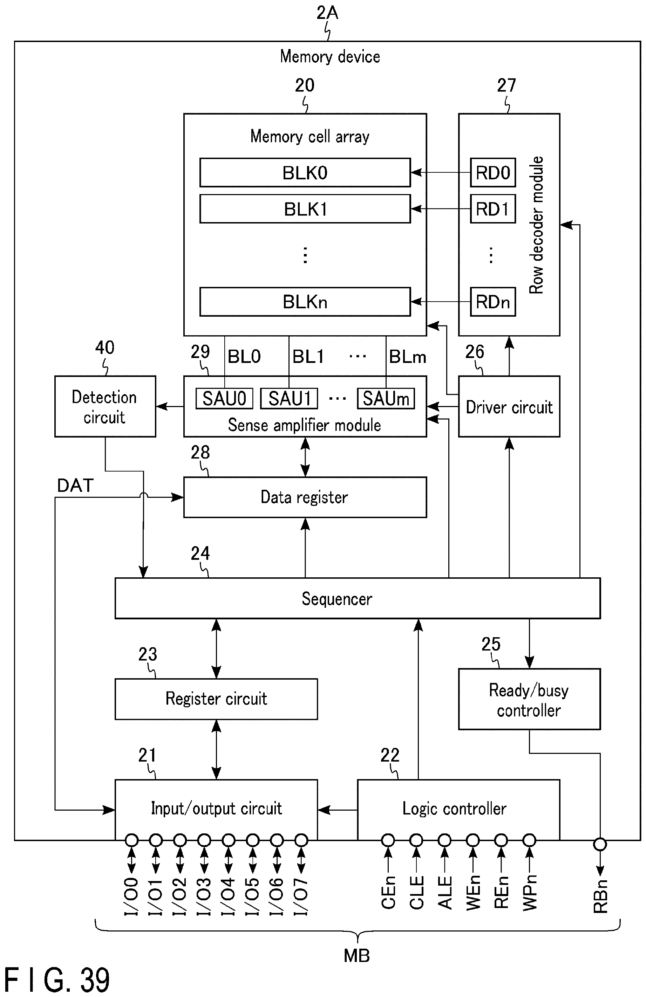

FIG. 39 is a block diagram illustrating an example of a hardware configuration of a memory device 2A included in the memory system MS according to the sixth embodiment. As illustrated in FIG. 39, the memory device 2A includes, for example, a memory cell array 20, an input/output circuit 21, a logic controller 22, a register circuit 23, a sequencer 24, a ready/busy controller 25, a driver circuit 26, a row decoder module 27, a data register 28, a sense amplifier module 29, and a detection circuit 40.

Each configuration of the memory cell array 20, the input/output circuit 21, the logic controller 22, the register circuit 23, the sequencer 24, the ready/busy controller 25, the driver circuit 26, the row decoder module 27, the data register 28, and the sense amplifier module 29 in the sixth embodiment is similar to that in the first embodiment. In the correction read operation, the detection circuit 40 detects the state of the page to be read based on a change in voltage of a specific node of the sense amplifier module 29. Then, the detection circuit 40 outputs the detection result to the sequencer 24. The sequencer 24 may determine a shift amount of the read voltage used in the correction read operation based on the detection result as in the first embodiment.

### <6-1-2> Circuit Configuration of Sense Amplifier Module 29 and Detection Circuit 40

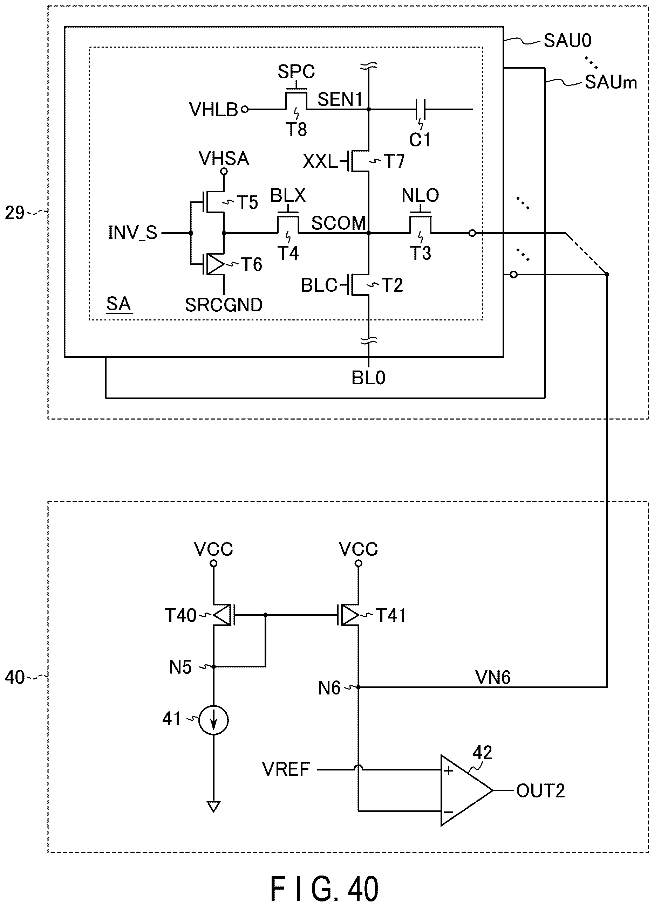

FIG. 40 is a diagram illustrating an example of a circuit configuration of the sense amplifier module 29 and the detection circuit 40 included in the memory device 2A according to the sixth embodiment. In FIG. 40, a part of the configuration of the sense amplifier module 29 including the transistor T3 of each sense amplifier unit SAU is illustrated. As illustrated in FIG. 40, the detection circuit 40 includes transistors T40 and 41, a constant current source 41, a comparator 42, and nodes N5 and N6. Each of the transistors T40 and T41 is a p-channel MOS transistor.

One end and a gate of the transistor T40 are coupled to the node N5. The power supply voltage VCC is applied to the other end of the transistor T40, for example. One end of the transistor T41 is coupled to the node N6. The power supply voltage VCC is applied to the other end of the transistor T41, for example. The gate of the transistor T41 is coupled to the node N5. One end of a current path of the constant current source 41 is coupled to the node N5. The other end of the current path of the constant current source 41 is coupled to a ground node. The current flowing through the node N5 is mirrored to the node N6 by the transistors T40 and T41 constituting a current mirror circuit. Hereinafter, the voltage of the node N6 is referred to as a voltage VN6.

The comparator 42 outputs a comparison result between the voltage of the first input end and the voltage of the second input end as an output signal OUT2. For example, the reference voltage VREF is applied to the first input end of the comparator 42. The second input end of the comparator 42 is coupled to the node N6. That is, the comparator 42 outputs a comparison result between the reference voltage VREF and the voltage VN6 as the output signal OUT2. For example, when each memory cell transistor MT of the NAND string NS is turned on and the amount of current flowing through the transistors T3 and T2 in each sense amplifier unit SAU increases, the voltage VN6 drops. As a result, for example, the comparator 42 can detect that the voltage VN6 is lower than the reference voltage VREF and reflect that the NAND string NS is turned on in the output signal OUT2.

As described above, the detection circuit 40 can indirectly detect the change in the current of the source line SL and reflect the change in the output signal OUT2. Note that the detection circuit 40 may have another circuit configuration as long as it can detect a change in the current of the NAND string NS.. Other configurations of the memory system MS according to the sixth embodiment is similar to those of the first embodiment.

### <6-2> Operation

Next, an operation of the memory system MS according to the sixth embodiment will be described.

### <6-2-1> Processing Procedure of Correction Read Operation

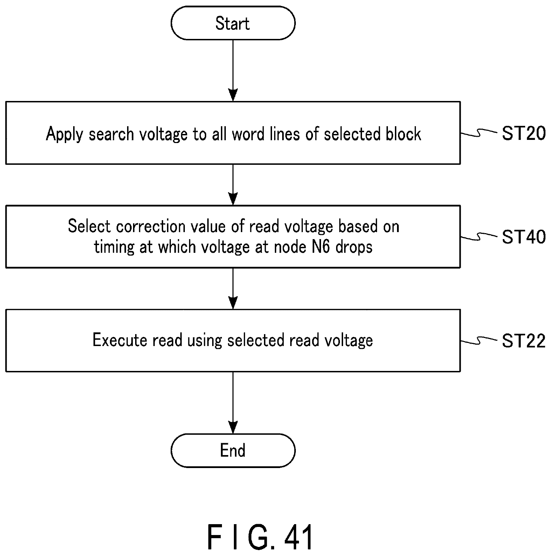

FIG. 41 is a flowchart illustrating an example of a processing procedure of a correction read operation of the memory device 2A according to the sixth embodiment. Upon receiving the instruction to execute the correction read operation from the memory controller 1, the memory device 2A starts a series of processing of FIG. 41 (start).

First, the memory device 2A applies a search voltage VLUMP to all the word lines WL of the selected block BLKsel as in the first embodiment (step ST20).

Next, the memory device 2A selects a correction value of the read voltage based on the timing at which the voltage at the node N6 drops (step ST40). A plurality of sets of correction values of the read voltage are prepared in association with each timing at which the voltage at the node N6 drops. In addition, the plurality of sets of correction values of the read voltage are stored in an area that can be referred to by the sequencer 24 during the correction read operation.

Next, as in the first embodiment, the memory device 2A executes a calibration read using the read voltage to which the selected correction value is applied (step ST22). When the calibration read is completed, the memory device 2A outputs the read result to the memory controller 1 and ends the series of processing of FIG. 41 (end).

### <6-2-1> Operation Waveform of Correction Read Operation

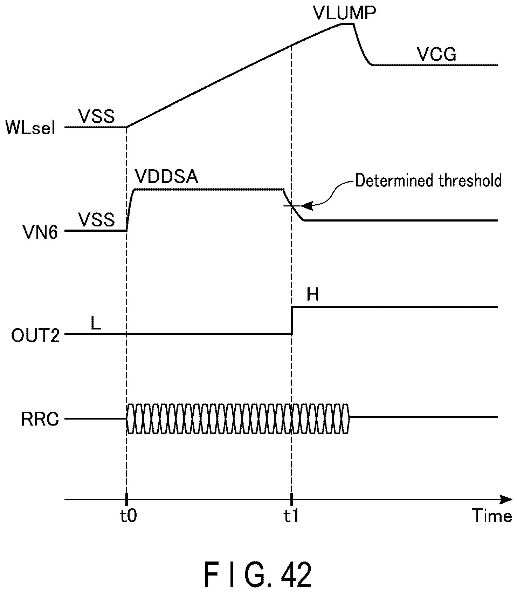

FIG. 42 is a diagram illustrating an example of an operation waveform of the correction read operation of the memory device 2 according to the sixth embodiment. In FIG. 42, a change in the voltage of each of the selected word line WLsel, the node N6, and the output signal OUT1 and a change in the control signal RRC in the correction read operation are illustrated. The control signal RRC is generated by, for example, the sequencer 24. In the present example, the control signal RRC is used to control the voltage applied to the word line WL. As illustrated in FIG. 42, in the correction read operation of the sixth embodiment, the sequencer 24 executes processing at times t0 and t1. At the start of the correction read operation, the voltage VN6 of the node N6 is the ground voltage VSS, and the output signal OUT2 is at the low level.

At time t0, the sequencer 24 applies the search voltage VLUMP to the selected word line WLsel as in the first embodiment. In addition, the sequencer 24 increases the voltage VN6 at the node N6 from the ground voltage VSS to VDDSA via the detection circuit 40. Then, the voltage VN6 of the node N6 is transferred to the selected bit line BLsel via the sense amplifier unit SAU. Thereafter, when the voltage of each word line WL rises and reaches the voltage corresponding to the bottom of the combined threshold voltage distribution, each memory cell transistor MT of the NAND string NS is turned on, and the current through the NAND string NS flows between almost all the bit lines BL and the source line SL. Then, the voltage VN6 of the node N6 drops due to the overcurrent. The comparator 42 of the detection circuit 40 changes the output signal from the low level to the high level in response to the dropped voltage VN6 falling below the reference voltage VREF.

As a result, the sequencer 24 can detect the bottom of the combined threshold voltage distribution, and can determine the correction value of the read voltage based on the timing of detecting the bottom of the combined threshold voltage distribution as in the first embodiment. Thereafter, the sequencer 24 executes calibration read similarly to the first embodiment using the determined correction value of the read voltage.

In the correction read operation, the sequencer 24 continuously transmits the control signal RRC in accordance with the rise of the word line WL. The control signal RRC indicates the voltage applied to the word line WL at the associated time. The sequencer 24 may determine the correction value of the read voltage based on the information of the control signal RRC transmitted at the timing when the output signal OUT2 becomes the high level. Other operations of the memory system MS according to the sixth embodiment is similar to those of the first embodiment.

### <6-3> Advantageous Effects of Sixth Embodiment

The memory system MS according to the sixth embodiment executes a search read for determining the degree of data retention and a calibration read in the correction read operation. Then, in the search read of the sixth embodiment, the voltages of all the word lines WL are increased similarly to the first embodiment, and the detection circuit 40 detects the bottom of the combined threshold voltage distribution based on the change in the voltage VN6 of the node N6 of the sense amplifier unit SAU.

As a result, in the memory device 2 according to the sixth embodiment, the sequencer 24 can determine the degree of data retention as in the first embodiment, and can determine a suitable shift amount of the read voltage. As a result, in the sixth embodiment, it is possible to provide a memory device and a memory system MS that have high reliability and operate at a high speed.

Note that the detection circuit 40 in the sixth embodiment can be realized by extension of existing circuit technology of a peripheral circuit. Therefore, it is easy to change from the existing circuit, and in some cases, it is also possible to perform refinement. The influence on the circuit area can be minimized. In the memory device 2 according to the sixth embodiment, the voltage of the source line SL in the read operation may be set to the ground voltage VSS instead of the voltage VSRC. That is, the correction read operation described in the sixth embodiment is not limited to the case of negative sensing.

### <7> Others

In the memory controller 1 in the above embodiments, a micro processing unit (MPU) may be used instead of the CPU 12. In addition, each of the processing described in the above embodiments can be executed by a dedicated hardware circuit, a processor that executes a program (firmware), or a combination thereof. The CPU 12 may be referred to as a processor. The sequencer 24 may be referred to as a controller. Assertion of the control signal STB by the sequencer 24 corresponds to an operation of temporarily changing the control signal STB from a low level to a high level or an operation of temporarily changing the control signal STB from a high level to a low level.

In the above embodiments, the case where the read processing is executed using the higher read voltage in order in the read operation has been exemplified, but the present invention is not limited thereto. In the read operation, the read processing may be executed using the lower read voltage in order. In the first to fifth embodiments, the information of the control signal RRC described in the sixth embodiment may be used to determine the timing at which the bottom of the combined threshold voltage distribution is detected.

The command sequences exemplified in the above embodiments are merely an example. The page to be read may be indicated by the address ADD. Any number can be applied to each of "xxh" and "yyh". The flowcharts used for the description in the above embodiments are merely examples. Other processing may be added to the processing illustrated in the flowcharts. In the present specification, the term "couple" refers to electrical coupling, and does not exclude interposition of another element therebetween. "Electrically coupled" may be via an insulator as long as it can operate in the same manner as electrically coupled. The word line WL, the select gate lines SGD and SGS, and the like may be simply referred to as "interconnect".

The high-level voltage is a voltage at which the n-channel MOS transistor to which the voltage at the level is applied to the gate is turned on and the p-channel MOS transistor to which the voltage at the level is applied to the gate is turned off. The low-level voltage is a voltage at which the n-channel MOS transistor to which the voltage at the level is applied to the gate is turned off and the p-channel MOS transistor to which the voltage at the level is applied to the gate is turned on. In the present specification, applying a voltage to the word line WL corresponds to the driver circuit 26 applying a voltage to the word line WL via the row decoder module 27. Similar to the word line WL, the applying of the voltage to the other interconnects also corresponds to the applying of the voltage by the driver circuit 26 via the row decoder module 27. The voltage of each interconnect may be estimated based on the voltage of the signal line connecting the driver circuit 26 and the row decoder module 27.

Some or all of the embodiments described above can be described as in the following supplementary notes, but is not limited thereto:

### [Supplementary Note 1]

A memory device comprising:
a plurality of strings (NS), each of the strings including a plurality of memory cells (MT) coupled in series;
a plurality of bit lines (BL), each of the strings having one end coupled to different bit line among the bit lines;
a plurality of word lines (WL) respectively coupled to the memory cells in each of the strings;
a source line (SL), each of the strings having the other end coupled to the source line; and
a controller (24) configured to execute a first read operation including a first read sequence and a second read sequence, wherein
the controller is further configured to:
   in the first read sequence, increase voltages of the word lines at the same speed, and determine a correction value of each of a plurality of read voltages based on a timing at which an amount of current through the strings changes with an increase in voltages of the word lines; and
   in the second read sequence, execute a read operation using the read voltages to which the correction value is applied.

### [Supplementary Note 2]

The memory device of Supplementary Note 1, wherein
in a case where each of the bit lines is a target to be read in the first read operation, the controller is further configured to:
charge only some bit lines of the bit lines when a voltage is applied to the word lines in the first read sequence; and
charge the bit lines when a read voltage is applied to the word lines in the second read sequence.

### [Supplementary Note 3]

The memory device of Supplementary Note 2, further comprising:
a driver circuit configured to apply a voltage to the word lines, wherein
the strings include a plurality of first strings coupled to the some bit lines and a plurality of second strings coupled to other bit lines, and
an interval between the driver circuit and a connection portion between the word lines is wider in the second strings than in the first strings.

### [Supplementary Note 4]

The memory device of Supplementary Note 1, further comprising:
an error amplifier (261) configured to maintain a voltage of the source line constant; and
a first detection circuit (30) configured to determine the timing based on a comparison result between a first reference current that changes based on an output of the error amplifier and a second reference current that is controlled to be constant, and notify the controller of a determination result.

### [Supplementary Note 5]

The memory device of Supplementary Note 1, further comprising:
a plurality of sense amplifiers (SAU) each coupled to the bit lines, each of the sense amplifiers being configured to be able to transfer a voltage applied to a first node (N6) to an associated bit line; and
a second detection circuit (40) configured to determine the timing based on a comparison result between a voltage of the first node that changes based on an amount of current flowing through the bit lines and a reference voltage controlled to be constant, and notify the controller of a determination result.

### [Supplementary Note 6]

The memory device of Supplementary Note 1, wherein
the controller is further configured to:
perform a second read operation using preset read voltage;
apply a first voltage (VPASS) to a unselected word line while applying a read voltage to a selected word line in the second read operation; and
a rising speed of voltages of the word lines in a first period (TP) included in the first read sequence is lower than a rising speed when the first voltage is applied to the unselected word line.

### [Supplementary Note 7]

The memory device of Supplementary Note 6, wherein
the controller is further configured to
set, in the first read sequence, until the first period is started, the rising speeds of voltages of the word lines to be similar to the rising speed when the first voltage is applied to the unselected word line in the second read operation.

### [Supplementary Note 8]

The memory device of Supplementary Note 1, wherein
the controller is further configured to
increase voltages of the word lines to a second voltage (VLUMP) and then decrease the voltages of the word lines in the first read sequence, and
detect the timing based on a decrease of the current through the strings as the voltages of the word lines decrease.

### [Supplementary Note 9]

The memory device of Supplementary Note 1, wherein
in the first read sequence, the controller is further configured to:
apply a third voltage (R1) to a unselected word line before being written among unselected word lines; and
apply a fourth voltage (VLUMP) higher than the third voltage to a written unselected word line.

### [Supplementary Note 10]

A memory system comprising:
the memory device according to Supplementary Note 9; and
a memory controller (1) configured to transmit information indicating whether or not a unselected word line associated with a block to be read has been written to the memory device before the first read operation.

### [Supplementary Note 11]

The memory device of Supplementary Note 1, wherein
the strings are divided into a plurality of sub-blocks (SBLK), and
in the first read sequence, a rising speed of voltage of a unselected word line associated with a unselected sub-block among the sub-blocks is faster than a rising speed of voltage of a unselected word line associated with a selected sub-block among the sub-blocks.

### [Supplementary Note 12]

The memory device of Supplementary Note 1, wherein
a highest read voltage among the read voltages used in the read operation is lower than a voltage applied to the word lines at the timing.

### [Supplementary Note 13]

A memory system comprising:
the memory device according to Supplementary Note 1; and
a memory controller (1) configured to instruct the memory device to execute a second read operation using a preset read voltage based on a command from an external host device, and in a case where error correction of data read from the memory device by the second read operation fails, instruct the memory device to execute the first read operation in which the same word line is selected.

### [Supplementary Note 14]

A memory device comprising:
a plurality of strings (NS), each of the strings including a plurality of memory cells (MT) coupled in series;
a plurality of bit lines (BL), each of the strings having one end coupled to different bit line among the bit lines;
a plurality of word lines (WL) respectively coupled to the memory cells in each of the strings;
a source line (SL), each of the strings having the other end coupled to the source line; and
a controller (24) configured to execute a first read operation including a first read sequence and a second read sequence, wherein
the controller is further configured to:
   in the first read sequence, search for a suitable read voltage;
   in the second read sequence;
   execute a read operation using the searched suitable read voltage; and
   while the lowest read voltage is applied, execute a plurality of times of read, and further execute final read based on a result of bit count of each of the times of read.

### [Supplementary Note 15]

The memory device of Supplementary Note 14, further comprising:
a plurality of sense amplifiers (SAU) each coupled to the bit lines, wherein
the controller is further configured to execute the times of read using some sense amplifiers of the sense amplifiers.

### [Supplementary Note 16]

The memory device of Supplementary Note 15, wherein
each of the sense amplifiers includes a first latch circuit and a second latch circuit, and
the controller is further configured to:
   cause the first latch circuit to hold a read result using the preferable read voltage used in the second read sequence;
   transfer data held in the first latch circuit of the some sense amplifiers to the second latch circuit before the times of read; and
   transfer, before the final read, data held in the second latch circuit of the some sense amplifiers to the first latch circuit.

### [Supplementary Note 17]

The memory device of Supplementary Note 16, wherein
each of the sense amplifiers includes a first latch circuit and a sense node (SEN), and
the controller is further configured to:
   cause the first latch circuit to hold a read result using the preferable read voltage used in the second read sequence;
   transfer data held in the first latch circuit of the some sense amplifiers to the sense node of another sense amplifier before the times of read; and
   transfer, before the final read, data held in the sense node of the other sense amplifier to the first latch circuit of the some sense amplifiers.

### [Supplementary Note 18]

The memory device of Supplementary Note 14, wherein
the controller is further configured to
in the first read sequence, increase voltages of the word lines at the same speed, and determine a suitable read voltage based on a timing at which the amount of current through the strings changes with the increase in the voltages of the word lines.

### [Supplementary Note 19]

The memory device of Supplementary Note 1, wherein
the controller is further configured to
in the first read sequence, execute read processing using a plurality of voltages near a highest read voltage, and determine a suitable read voltage used in the second read sequence based on a result of each bit count of the read processing using the voltages.

### [Supplementary Note 20]

A memory system comprising:
the memory device according to Supplementary Note 14; and
a memory controller (1) configured to instruct the memory device to execute a second read operation using a preset read voltage based on a command from an external host device, and in a case where error correction of data read from the memory device by the second read operation fails, instruct the memory device to execute the first read operation in which the same word line is selected.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or further embodiment as would fall within the scope and spirit of the inventions.

## Claims

1. A memory device comprising:
a plurality of strings (NS), each of the strings including a plurality of memory cells (MT) coupled in series;
a plurality of bit lines (BL), each of the strings having one end coupled to different bit line among the bit lines;
a plurality of word lines (WL) respectively coupled to the memory cells in each of the strings;
a source line (SL), each of the strings having the other end coupled to the source line; and
a controller (24) configured to execute a first read operation including a first read sequence and a second read sequence, wherein
the controller is further configured to:
in the first read sequence, increase voltages of the word lines at the same speed, and determine a correction value of each of a plurality of read voltages based on a timing at which an amount of current through the strings changes with an increase in voltages of the word lines; and
in the second read sequence, execute a read operation using the read voltages to which the correction value is applied.

2. The memory device of claim 1, wherein
in a case where each of the bit lines is a target to be read in the first read operation, the controller is further configured to:
charge only some bit lines of the bit lines when a voltage is applied to the word lines in the first read sequence; and
charge the bit lines when a read voltage is applied to the word lines in the second read sequence.

3. The memory device of claim 2, further comprising:
a driver circuit configured to apply a voltage to the word lines, wherein
the strings include a plurality of first strings coupled to the some bit lines and a plurality of second strings coupled to other bit lines, and
an interval between the driver circuit and a connection portion between the word lines is wider in the second strings than in the first strings.

4. The memory device of claim 1, further comprising:
an error amplifier (261) configured to maintain a voltage of the source line constant; and
a first detection circuit (30) configured to determine the timing based on a comparison result between a first reference current that changes based on an output of the error amplifier and a second reference current that is controlled to be constant, and notify the controller of a determination result.

5. The memory device of claim 1, further comprising:
a plurality of sense amplifiers (SAU) each coupled to the bit lines, each of the sense amplifiers being configured to be able to transfer a voltage applied to a first node (N6) to an associated bit line; and
a second detection circuit (40) configured to determine the timing based on a comparison result between a voltage of the first node that changes based on an amount of current flowing through the bit lines and a reference voltage controlled to be constant, and notify the controller of a determination result.

6. The memory device of claim 1, wherein
the controller is further configured to:
perform a second read operation using preset read voltage;
apply a first voltage (VPASS) to a unselected word line while applying a read voltage to a selected word line in the second read operation; and
a rising speed of voltages of the word lines in a first period (TP) included in the first read sequence is lower than a rising speed when the first voltage is applied to the unselected word line.

7. The memory device of claim 6, wherein
the controller is further configured to
set, in the first read sequence, until the first period is started, the rising speeds of voltages of the word lines to be similar to the rising speed when the first voltage is applied to the unselected word line in the second read operation.

8. The memory device of claim 1, wherein
the controller is further configured to
increase voltages of the word lines to a second voltage (VLUMP) and then decrease the voltages of the word lines in the first read sequence, and
detect the timing based on a decrease of the current through the strings as the voltages of the word lines decrease.

9. The memory device of claim 1, wherein
in the first read sequence, the controller is further configured to:
apply a third voltage (R1) to a unselected word line before being written among unselected word lines; and
apply a fourth voltage (VLUMP) higher than the third voltage to a written unselected word line.

10. A memory system comprising:
the memory device according to claim 9; and
a memory controller (1) configured to transmit information indicating whether or not a unselected word line associated with a block to be read has been written to the memory device before the first read operation.

11. The memory device of claim 1, wherein
the strings are divided into a plurality of sub-blocks (SBLK), and
in the first read sequence, a rising speed of voltage of a unselected word line associated with a unselected sub-block among the sub-blocks is faster than a rising speed of voltage of a unselected word line associated with a selected sub-block among the sub-blocks.

12. The memory device of claim 1, wherein
a highest read voltage among the read voltages used in the read operation is lower than a voltage applied to the word lines at the timing.

13. A memory system comprising:
the memory device according to claim 1; and
a memory controller (1) configured to instruct the memory device to execute a second read operation using a preset read voltage based on a command from an external host device, and in a case where error correction of data read from the memory device by the second read operation fails, instruct the memory device to execute the first read operation in which the same word line is selected.

14. A memory device comprising:
a plurality of strings (NS), each of the strings including a plurality of memory cells (MT) coupled in series;
a plurality of bit lines (BL), each of the strings having one end coupled to different bit line among the bit lines;
a plurality of word lines (WL) respectively coupled to the memory cells in each of the strings;
a source line (SL), each of the strings having the other end coupled to the source line; and
a controller (24) configured to execute a first read operation including a first read sequence and a second read sequence, wherein
the controller is further configured to:
in the first read sequence, search for a suitable read voltage;
in the second read sequence;
execute a read operation using the searched suitable read voltage; and
while the lowest read voltage is applied, execute a plurality of times of read, and further execute final read based on a result of bit count of each of the times of read.

15. The memory device of claim 14, further comprising:
a plurality of sense amplifiers (SAU) each coupled to the bit lines, wherein
the controller is further configured to execute the times of read using some sense amplifiers of the sense amplifiers.

16. The memory device of claim 15, wherein
each of the sense amplifiers includes a first latch circuit and a second latch circuit, and
the controller is further configured to:
cause the first latch circuit to hold a read result using the preferable read voltage used in the second read sequence;
transfer data held in the first latch circuit of the some sense amplifiers to the second latch circuit before the times of read; and
transfer, before the final read, data held in the second latch circuit of the some sense amplifiers to the first latch circuit.

17. The memory device of claim 16, wherein
each of the sense amplifiers includes a first latch circuit and a sense node (SEN), and
the controller is further configured to:
cause the first latch circuit to hold a read result using the preferable read voltage used in the second read sequence;
transfer data held in the first latch circuit of the some sense amplifiers to the sense node of another sense amplifier before the times of read; and
transfer, before the final read, data held in the sense node of the other sense amplifier to the first latch circuit of the some sense amplifiers.

18. The memory device of claim 14, wherein
the controller is further configured to
in the first read sequence, increase voltages of the word lines at the same speed, and determine a suitable read voltage based on a timing at which the amount of current through the strings changes with the increase in the voltages of the word lines.

19. The memory device of claim 1, wherein
the controller is further configured to
in the first read sequence, execute read processing using a plurality of voltages near a highest read voltage, and determine a suitable read voltage used in the second read sequence based on a result of each bit count of the read processing using the voltages.

20. A memory system comprising:
the memory device according to claim 14; and
a memory controller (1) configured to instruct the memory device to execute a second read operation using a preset read voltage based on a command from an external host device, and in a case where error correction of data read from the memory device by the second read operation fails, instruct the memory device to execute the first read operation in which the same word line is selected.
